# EUROPEAN PATENT SPECIFICATION

(11) **EP 3 352 364 B1**
(45) Date of publication and mention of the grant of the patent: **26.10.2022**
(21) Application number: 16846360.2
(22) Date of filing: 08.09.2016
(51) Int. Cl.: H02M 7/48, G01R 29/18, H02H 3/34, H02J 3/18, H02M 7/06, H02M 5/44, H02M 5/453, H02M 5/458

(54) **INVERTER SUBSTRATE, METHOD FOR DETERMINING CONNECTION SEQUENCE, AND METHOD FOR DETERMINING OPEN PHASE**
INVERTERSUBSTRAT, VERFAHREN ZUR BESTIMMUNG DER ANSCHLUSSSEQUENZ UND VERFAHREN ZUR BESTIMMUNG EINER OFFENEN PHASE
SUBSTRAT D'ONDULEUR, PROCÉDÉ DE DÉTERMINATION DE SÉQUENCE DE CONNEXION, ET PROCÉDÉ DE DÉTERMINATION DE PHASE OUVERTE

(30) Priority: 14.09.2015 JP 2015180570
(43) Date of publication of application: 25.07.2018
(73) Proprietor: Daikin Industries, Ltd., Osaka 530-8323 (JP)
(72) Inventor: KAWASHIMA Reiji, Osaka 530-8323 (JP)
(74) Representative: Hoffmann Eitle
(86) International application number: PCT/JP2016/076394
(87) International publication number: WO 2017/047489

(56) References cited:
- DE-A1- 3 228 954
- JP-A- H10 248 260
- JP-A- H10 248 260
- JP-A- 2001 091 600
- JP-A- 2001 091 600
- JP-A- 2002 055 136
- JP-A- 2002 064 989
- JP-A- 2002 354 826
- JP-A- 2002 354 826
- JP-A- 2008 312 360
- JP-A- 2014 207 798
- JP-A- 2015 070 659
- JP-A- 2015 092 813
- JP-A- 2015 162 998
- BHATTACHARYA S ET AL: "Parallel active filter system implementation and design issues for utility interface of adjustable speed drive systems", CONFERENCE RECORD OF THE 1996 IEEE INDUSTRY APPLICATIONS CONFERENCE - 31ST IAS ANNUAL MEE, IEEE SERVICE CENTER, US, vol. 2, 6 October 1996 (1996-10-06), pages 1032-1039, XP010201422, DOI: 10.1109/IAS.1996.560208 ISBN: 978-0-7803-3544-8

## Description

### Technical Field

The present invention relates to an inverter substrate connected to a three-phase power source line and an active filter, a method of determining an order of power source phase in the connection, and a method of determining an open phase.

### Background Art

A harmonic current generated in electrical facilities provided by consumers of electrical power has a regulated upper limit of total amount thereof. For example, the upper limited is regulated in Non-Patent Document 1 in Japan. An operation of an inverter in the electrical facilities contributes to the generation of the harmonic current. A standard similar to that in Non-Patent Document 1 is also provided in the United States of America (refer to Non-Patent Document 2) and the United Kingdom (refer to Non-Patent Document 3).

An installation of an active filter is adopted as one method of reducing the harmonic current. A total number of active filters to be installed is selected in accordance with a generation amount of the harmonic current for each consumer. Accordingly, the active filter is often installed on-the spot.

When the active filter is installed on-the-spot as described above, a three-phase power source line is already connected to the inverter to which the active filter is to be connected. Accordingly, the active filter needs to be connected to the three-phase power source line in conformity with an order of power source phase in which the inverter is connected to the three-phase power source line (also referred to simply as "phase order" hereinafter).

Therefore proposed are an additional circuit dealing with a case where the phase order of the active filter with respect to the three-phase power source line is different from that of the inverter and a determination processing for determining the phase order accurately.

For example, Patent Document 1 described below proposes a zero cross detection means of detecting a zero cross point of an interphase voltage of a power source (considered to mean a line voltage) and a current detection means of detecting current flowing in a power conversion device that generates the harmonic current. An open phase of the power source is detected based on a signal output state of a different interphase in the zero cross detection means. Abnormality in the phase order of the power source is detected based on the signal output state described above and a phase difference of the signal output. Abnormality in a connection with respect to the power source in the current detection means is detected on the basis of the signal output state of the zero cross detection means and the current detection result of the current detection means.

When there is imbalance among the interphase voltages of the three-phase power source, imbalance also occurs in current flowing in the inverter. When the imbalance occurs, an intended current cannot be detected in a predetermined phase section, so that it is erroneously determined that there is the abnormality in the current though a connection state of a current detection means is normal.

Thus, Patent Document 2 described below proposes a line-voltage zero cross detection means to detect the zero cross point of the interphase voltage of a commercial power supply as a reference phase, a current imbalance state detection means to detect a coefficient related to a current imbalance state on the basis of current detected values related to the detection of current detectors that detect a current flowing from the power supply, a fundamental wave component calculation means which calculates a fundamental wave component of a current related to the detection of the current detectors, and a phase angle determination means to determine the connection abnormality in the current detectors on the basis of the reference phase, the current imbalance state, and the fundamental wave component of the current.

Patent Document 3 is cited as a known technique for describing a cooperation between the inverter and the active filter. Non-Patent Documents 4 and 5 are cited as known techniques for describing a so-called electrolytic capacitor-less inverter (this is referred to as "the capacitor-less inverter" in the descriptions).

Further, Patent Document 4 describes an inverter controlling method and its apparatus equipped with with a conventional capacitorless inverter controlling unit, an I₁ operation part 12 which operates a number 10 by inputting a motor torque Tₘ, the number of revolution of a motor, a power source voltage V₁ and a coefficient q, calculates a power source current i-|, and outputs a power source current command value i-|^{∗}; a feedback operation part 13 which inputs the command value i-i^{∗} and the real current i-|, performs operation (e.g. PI operation) in which deviation of them becomes zero, and outputs a torque command for correction or a torque current command; and a subtraction part 14 which subtracts the torque command for correction or the torque current command outputted from the feedback operation part 13 from a temporary torque command, or a torque current command outputted from the inverter controlling unit 11.

Still Further, Patent Document 5 describes a main circuit connection judging method to judge whether a main circuit wiring is properly connected or not by comparing the current of two phases of a current detection circuit when the voltage of one phase of a power supply phase voltage detection circuit except the two phases of the current detection circuit passes an inflexion point. A power supply phase voltage detection circuit 5 and a current detection circuit 6 for two phases are provided between a capacitor-input-type rectifying circuit 2 and a three-phase AC power supply L; Then, one switching element of the upper and lower arms of the rectifying circuit 2 is collectively turned on, and the current for two phases of the current detection circuit 6 is compared when the voltage of the other phase of a power supply phase voltage detection circuit 5 except the two phases of the current detection circuit 6 passes a inflexion point, thus determining whether a main circuit wiring is properly connected to the detection terminal of the power supply phase voltage detection circuit 5 or not, more specifically whether the main circuit wiring is connected properly or not.

Also, Patent Document 6 describes a protection device for asynchronous motors for monitoring, in particular inverter-fed asynchronous motors.

Finally, Non-Patent Document 6 presents a parallel active filter system implementation for utility interface of an adjustable speed drive air-conditioner chiller application to meet IEEE 519 recommended harmonic standards.

### Prior Art Documents

### Patent Documents

Patent Document 1: JP 2001 091600 A
Patent Document 2: Japanese Patent Application Laid-Open No. 2011-188592
Patent Document 3: Japanese Patent Application Laid-Open No. 2014-207747
Patent Document 4: JP 2002 354826 A
Patent Document 5: JP H10 248260 A
Patent Document 6: DE 32 28 954 A1

### Non-Patent Documents

Non-Patent Document 1: "Guideline of Harmonics Reduction for Consumers who have High or Ultra-High Voltage Power Receiving Facilities", enacted in January 2004, Nuclear and Industrial Safety Agency
Non-Patent Document 2: "IEEE Recommended Practices and Requirements for Harmonic Control in Electrical Power Systems", IEEE Std 519-1992 (1993)
Non-Patent Document 3: "MANAGING HARMONICS A guide to ENA Engineering Recommendation G5/4-1 fifth edition", GAMBICA (2006)
Non-Patent Document 4: "Control of the Capacitor-less Inverter", Takahashi and Itou, Annual Meeting Record, I.E.E.JAPAN 1988, P624
Non-Patent Document 5: "Capacitor-less PWM Inverter Control Method", Itou, Takahashi, and Miyagawa, Annual Meeting Record, I.E.E.JAPAN 1988, PP625-626
Non-Patent Document 6: BHATTACHARYA S ET AL: "Parallel active filter system implementation and design issues for utility interface of adjustable speed drive systems", XP010201422

### Summary

The invention provides an inverter substrate according to claim 1, a method of determining an order of connection between an inverter substrate and three-phase power source lines according to claim 5, and a method of determining an open phase in an inverter substrate according to claim 15. Preferred embodiments are defined in the dependent claims.

### Problem to be Solved by the Invention

In the technique proposed in Patent Document 1, the zero cross signal of the different interphase needs to be detected using the plurality of zero cross detection means to detect the open phase of the power source and the abnormality in the phase order. The technique proposed in Patent Document 2 needs many additional circuits such as the current imbalance state detection means.

Accordingly, an object of the present application is to provide a technique of detecting abnormality in a phase order with a simple configuration. Another object is to provide a technique of detecting an open phase.

### Means to Solve the Problem

A first aspect of an inverter substrate according to the present invention (100A, 100B) includes the features of claim 1.

A second aspect of the inverter substrate according to the present invention (100B) further includes, in the first aspect, a parallel active filter (200B) providing the first to third input terminals (5t, 5r, 5s) with three-phase compensating currents (Iu, Iv, Iw) based on the line voltage (Vrs) or the phase voltage (Vrn), and the first current (It) by a predetermined correspondence relationship.

According to a third aspect of the inverter substrate (100B) according to the present invention, in the first or second aspect, the first current (It) is applied to control both the inverter (4) and the active filter (200B).

According to a fourth aspect of the inverter substrate (100A, 100B) according to the present invention, in any of first to third aspects, the rectifier circuit (2) performs a six-pulse rectification.

According to a fifth aspect of the present invention there is provided a method of determining a connection order between an inverter substrate (100A, 100B) and the power source lines (1t, 1r, 1s). In the method according to the fifth aspect a connection order between the first to third input terminals (5t, 5r, 5s) and the power source lines is determined on the basis of the line voltage (Vrs) or the phase voltage (Vrn), and at least the first current (It).

According to a sixth aspect, the inverter substrate (100A, 100B) comprises the features of claim 5, a connection order between the first to third input terminals (5t, 5r, 5s) and the power source lines (1t, 1r, 1s) is determined by comparing the first current (It) at a specific point of time with at least one threshold value The specific point of time is a point of time after a lapse of time (td) of N/12 times a cycle of the line voltage (Vrs) (N = 1, 5, 7, or 11) from a point of time when the line voltage takes a value zero or a point of time when the phase voltage (Vrn) takes a value zero or a point of time after a lapse of time (td) of M/12 times a cycle of the phase voltage (M = 2, 4, 6, 8, or 10) from the point of time.

According to a seventh aspect in the method according to the fifth aspect of the present invention, a connection order between the first to third input terminals (5t, 5r, 5s) and the power source lines (1t, 1r, 1s) is determined by comparing an average value of the first current (It) in a specific period of time with at least one threshold value. The specific period of time is a period of a length of time (d) of 1/12 times a cycle of the line voltage (Vrs) immediately after a lapse of time (td) of N/12 times the cycle (N = 1, 5, 7, or 11) from the point of time when the line voltage (Vrn) takes a value zero or a period of a length of time (d) of 1/12 times a cycle of the phase voltage immediately after a point of time when the phase voltage (Vrn) takes a value zero or when time (td) of M/12 times the cycle (M = 2, 4, 6, 8, or 10) has elapsed from the point of time.

According to an eighth aspect in the method according to the fifth aspect of the present invention, a connection order between the first to third input terminals (5t, 5r, 5s) and the power source lines (1t, 1r, 1s) is determined in accordance with increase and decrease in the first current (It) in a specific period of time. The specific period of time is a period of a length of time (d) of 1/12 times a cycle of the line voltage (Vrs) immediately after at a point of time when the line voltage (Vrs) takes a value zero or when time (td) of N/12 times the cycle (N = 4, 6, or 10) has elapsed from the point of time or a period of a length of time (d) of 1/12 times a cycle of the phase voltage immediately after a lapse of time (td) of M/12 times the cycle (M = 1, 3, 5, 7, 9, or 11) from a point of time when the phase voltage (Vrn) takes a value zero.

According to a ninth aspect in the method according to the fifth aspect of the present invention, a connection order between the first to third input terminals (5t, 5r, 5s) and the power source lines (1t, 1r, 1s) is determined in accordance with a magnitude relationship at a specific point of time between the first current (It) and a second current (1r) flowing in the second input end (2r). The specific point of time is a point of time after a lapse of time (td) of N/12 times a cycle of the line voltage (Vrs) (N = 1, 5, 7, or 11) from a point of time when the line voltage takes a value zero or a point of time when the phase voltage (Vrn) takes a value zero.

According to a tenth aspect in the method according to the fifth aspect of the present invention, a connection order between the first to third input terminals (5t, 5r, 5s) and the power source lines (1t, 1r, 1s) is determined in accordance with a magnitude relationship at a specific point of time between the first current (It) and a second current (Is) flowing in the third input end (2s). The specific point of time is a point of time after a lapse of time (td) of N/12 times a cycle of the line voltage (Vrs) (N = 1, 5, 7, or 11) from a point of time when the line voltage takes a value zero or a point of time when the phase voltage (Vrn) takes a value zero or a point of time after a lapse of time (td) of M/12 times a cycle of the phase voltage (M = 2, 4, 6, or 8) from the point of time.

According to an eleventh aspect of the present invention, in the method according to the fifth aspect of the present invention, the inverter substrate (100A, 100B) further includes a second current detector detecting the second current (Ir; Is). Alternatively, the second current (Ir; Is) is estimated by shifting a phase of the first current (It).

According to a twelvth aspect of the present invention, in the method according to the ninth or tenth aspect of the present invention, the second current (Ir; Is) is estimated by shifting a phase of the first current (It).

According to a thirteenth aspect in the method according to the fifth aspect of the present invention, the inverter substrate further includes a second current detector detecting a second current (Ir; Is) flowing in one of the second input end (2r) and the third input end (2s), and the rectifier circuit (2) is a diode bridge. Then, a third current (Is; Ir) flowing in the other one of the second input end and the third input end is obtained from the first current and the second current, an estimated value (Φ^) of a phase (Φ) of one of the AC voltages (Vt, Vr, Vs) is obtained from the phase voltage (Vrn) or the line voltage (Vrs), a current component (Id) having the same phase as a phase of the estimated value is obtained by performing a three phase/two phase conversion of the first current, the second current, and the third current on the basis of the estimated value, and a connection order between the first to third input terminals (5t, 5r, and 5s) and the power source line is estimated in accordance with presence or absence of a variation of a polarity of the current component in a half cycle of the line voltage.

According to a fourteenth aspect in the method according to the fifth aspect of the present invention, the inverter substrate further includes a second current detector detecting a second current (Ir; Is) flowing in one of the second input end (2r) and the third input end (2s), and the rectifier circuit (2) is a diode bridge. Then, a third current (Is; Ir) flowing in the other one of the second input end and the third input end is obtained from the first current and the second current, an estimated value (Φ^) of a phase (Φ) of one of the AC voltages (Vt, Vr, Vs) from the phase voltage (Vrn) or the line voltage (Vrs) is obtained, a current component (Id; Iq), a phase of which is the same as or orthogonal to a phase of the estimated value, is obtained by performing a three phase/two phase conversion of the first current, the second current, and the third current on the basis of the estimated value, and a connection order between the first to third input terminals (5t, 5r, and 5s) and the power source lines (15, 1r, 1s) is determined in accordance with a determination whether or not a DC component (Id0; Iq0) of the current component exceeds a predetermined value.

According to a fifteenth aspect of the present invention, there is provided a method of determining an open phase wherein it is determined in the inverter substrate (100A, 100B) according to the first to fourth aspect of the present invention that an open phase occurs in one of the first to third input terminals (5t, 5r, 5s) when a magnitude of the first current (It) at a specific point of time is smaller than a predetermined value. The specific point of time is a point of time after a lapse of time (td) of N/12 times a cycle of the line voltage (Vrs) (N = 1, 5, 7, or 11) from a point of time when the line voltage takes a value zero or a point of time when the phase voltage (Vrn) takes a value zero.

### Effects of the Invention

According to the first aspect of the inverter substrate according to the present invention, there is a correspondence relationship between the input terminal and the input end, and the current flowing in the input end corresponding to a predetermined input terminal is detected, thus the connection order between the input terminal and the power source line is detected with a simple configuration. Also, the number of components is reduced.

According to the second aspect of the inverter substrate according to the present invention, the compensating current corresponding to the connection order between the input terminal and the power source line is obtained from the active filter.

According to the fourth aspect of the inverter substrate according to the present invention, the connection order between the input terminal and the power source line can be easily detected even when there is imbalance in a power source.

According to the method of determining the connection order according to the fifth aspect of the present invention, a phase order is determined with a simple configuration. Particularly, the fourth aspect and the fifth aspect are more accurate than the first to third aspect, and the seventh aspect is more accurate than the sixth aspect.

According to the method of determining an open phase according to the fifteenth aspect of the present invention, presence and absence of the open phase is determined.

These and other objects, features, aspects and advantages of the present invention will become more apparent from the following detailed description of the present invention when taken in conjunction with the accompanying drawings.

### Brief Description of Drawings

Fig. 1 is a circuit diagram illustrating a configuration of an inverter substrate according to a first embodiment;
Fig. 2 is a circuit diagram illustrating a configuration of the inverter substrate according to the first embodiment;
Fig. 3 is a graph illustrating various amounts in a case where a positive phase connection is obtained;
Fig. 4 is a graph illustrating various amounts in a case where a negative phase connection is obtained;
Fig. 5 is a circuit diagram partially illustrating a case where a three-phase power source is a three-phase four-wire type that also outputs neutral-point potential;
Fig. 6 is a graph illustrating various amounts in a case where a positive phase connection is obtained;
Fig. 7 is a graph illustrating various amounts in a case where a negative phase connection is obtained;
Fig. 8 is a graph illustrating various amounts in a case where an open phase occurs;
Fig. 9 is a circuit diagram illustrating a configuration of an inverter substrate according to a second embodiment;
Fig. 10 is a graph illustrating various amounts in a case where a positive phase connection is obtained;
Fig. 11 is a graph illustrating various amounts in a case where a positive phase connection is obtained;
Fig. 12 is a circuit diagram illustrating a configuration of a zero cross signal generator as an example;
Fig. 13 is a circuit diagram illustrating a configuration of a zero cross signal generator as an example; and
Fig. 14 is a circuit diagram illustrating a comparison example compared with the first embodiment.

### Description of Embodiment(s)

### First embodiment.

### <Configuration>

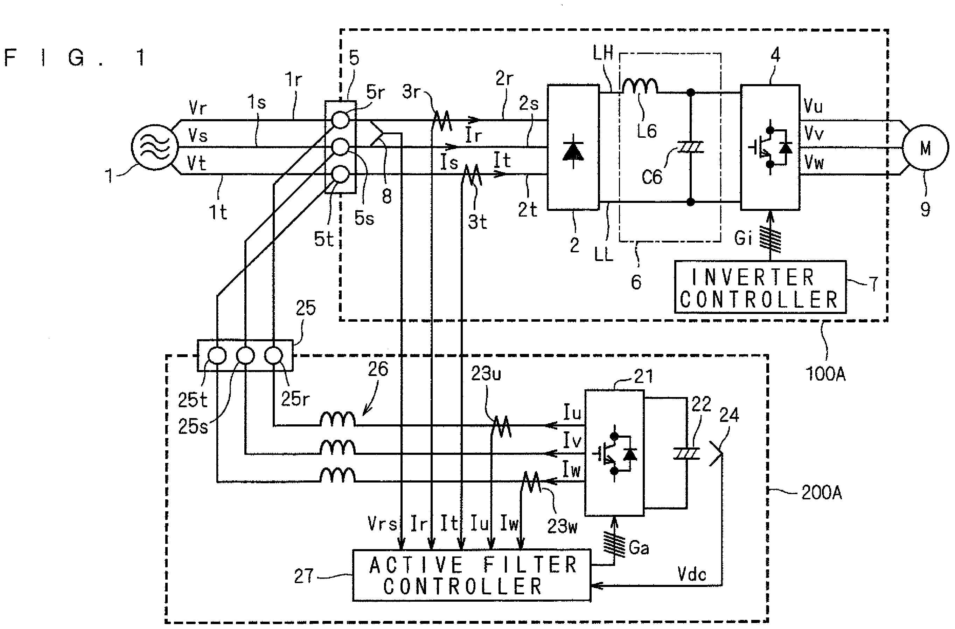

Fig. 1 is a circuit diagram illustrating a configuration of an inverter substrate 100A according to the first embodiment and a connection relationship with the other constituent element connected to the inverter substrate 100A.

The inverter substrate 100A includes a pair of DC buses LH and LL, a rectifier circuit 2, and an inverter 4.

The inverter substrate 100A is connected to a three-phase power source 1 via three-phase power source lines 1r, 1s, and 1t. Specifically, the inverter substrate 100A further includes an input connection unit 5, through which the inverter 4 is connected to the three-phase power source lines 1r, 1s, and 1t. Three-phase AC voltages Vr, Vs, and Vt being output from the three-phase power source 1 are applied to the power source lines 1r, 1s, and 1t, respectively. Described hereinafter for convenience is a case where the AC voltage Vr is more advanced than the AC voltage Vs by 120 degrees, and the AC voltage Vs is more advanced than the AC voltage Vt by 120 degrees.

The rectifier circuit 2 has three input ends 2r, 2s, and 2t, and applies DC voltages obtained by rectifying the AC voltages Vr, Vs, and Vt to the DC buses LH and LL. The DC bus LH has higher potential than the DC bus LL. The rectifier circuit 2 is achieved by a diode bridge, for example.

The inverter 4 converts the DC voltages into the other AC voltages Vu, Vv, and Vw and outputs them. For example, the inverter 4 applies the AC voltages Vu, Vv, and Vw to a motor 9 connected to the inverter substrate 100A.

The input connection unit 5 has the three input terminals 5r, 5s, and 5t, and the three-phase power source lines 1r, 1s, and 1t are connected to them. The input terminals 5r, 5s, and 5t correspond to the input ends 2r, 2s, and 2t, respectively, and the input terminals 5r, 5s, and 5t are connected to the input ends 2r, 2s, and 2t, respectively.

An output connection unit 25 included in an active filter 200A is also connected to the input connection unit 5. Specifically, the output connection unit 25 includes three output terminals 25r, 25s, and 25t, and they are connected to input terminals 5r, 5s, and 5t, respectively. Three phase compensating currents Iu, Iv, and Iw are supplied to the input terminals 5r, 5s, and 5t corresponding to the three phase compensating currents Iu, Iv, and Iw (that is to say, having a predetermined correspondence relationship), respectively, via the output terminals 25r, 25s, and 25t.

In the inverter substrate 100A, the AC voltages Vr, Vs, and Vt are once converted into the DC voltages, and then converted into the AC voltages Vu, Vv, and Vw. Thus, any phase order is available in a function of the inverter substrate 100A itself. In other words, the input terminals 5r, 5s, and 5t need not necessarily be connected to the power source lines 1r, 1s, and 1t, respectively, in this order.

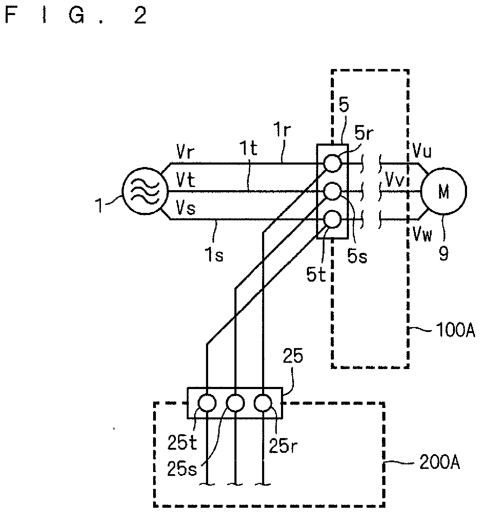

However, for convenience of subsequently describing an operation of the active filter, a case where the input terminals 5r, 5s, and 5t are connected to the power source lines 1r, 1s, and 1t, respectively, in this order is referred to as a positive phase connection, and a case where the input terminals 5r, 5s, and 5t are connected to the power source lines 1r, 1t, and 1s, respectively, in this order is referred to as a negative phase connection. Fig. 1 illustrates a case of the positive phase connection. Fig. 2 is a circuit diagram partially illustrating a case where the input terminals 5r, 5s, and 5t are connected to the power source lines 1r, 1t, and 1s, respectively, in this order. A part omitted in Fig. 2 is the same as that of Fig. 1.

There may also be a case where the input terminals 5r, 5s, and 5t are connected to the power source lines 1s, 1t, and 1r, respectively, in this order, or are connected to the power source lines 1t, 1r, and 1s, respectively, in this order. However, since three-phase voltages can also be dealt with in such two cases in a manner similar to the case of the positive phase connection described above, the description of these two cases is omitted.

Similarly, there may also be a case where the input terminals 5r, 5s, and 5t are connected to the power source lines 1s, 1r, and 1t, respectively, in this order, or are connected to the power source lines 1t, 1s, and 1r, respectively, in this order. However, since the three-phase voltages can also be dealt with in such two cases in a manner similar to the case of the negative phase connection described above, the description of these two cases is omitted.

The inverter substrate 100A further includes a smoothing filter 6 provided in the DC buses LH and LL. The smoothing filter 6 is, for example, a choke input type LC filter, and has an inductor L6 and a capacitor C6. The smoothing filter 6 smooths the DC voltage which the rectifier circuit 2 applies to the DC buses LH and LL, and inputs the smoothed DC voltage to the inverter 4.

The inverter substrate 100A further includes an inverter controller 7 controlling an operation of the inverter 4. In the inverter 4, for example, three current paths each having an upper arm switching element and a lower arm switching element are connected in parallel with each other between the DC buses LH and LL. The inverter controller 7 provides the inverter 4 with a drive signal Gi for controlling opening and closing of the three pairs of upper arm switching element and the lower arm switching element.

Since the configuration and the connection relationship between these rectifier circuit 2, the smoothing filter 6, the inverter 4, and the inverter controller 7 and the like are publicly known in Patent Document 3, for example, the more detailed description is omitted herein.

The inverter substrate 100A further includes a voltage detector 8 and a current detector 3t. The voltage detector 8 detects a line voltage Vrs between the input terminals 5r and 5s. More specifically, the line voltage Vrs is the voltage of the input terminal 5r based on the potential of the input terminal 5s. The current detector 3t detects a load current It flowing in the input end 2t.

Since the configuration of the voltage detector 8 and the current detector 3t can be achieved by a known technique, the description is omitted here.

The voltage to be detected by the voltage detector 8 is different depending on which of the positive phase connection or the negative phase connection occurs. Specifically, when the positive phase connection is obtained, as illustrated in Fig. 1, the power source lines 1r and 1s are connected to the input terminals 5r and 5s, respectively, thus the voltage of the AC voltage Vr based on the AC voltage Vs is detected as the line voltage Vrs. In contrast, when the negative phase connection is obtained, the power source lines 1r and 1t are connected to the input terminals 5r and 5s, respectively, thus the voltage of the AC voltage Vr based on the AC voltage Vt is detected as the line voltage Vrs.

Similarly, the current to be detected by the current detector 3t is different depending on which of the positive phase connection or the negative phase connection occurs. Specifically, the current obtained by compensating the current obtained from the power source line It with a compensating current Iw, which is described hereinafter, is detected as the load current It in the case where the positive phase connection is obtained, and the current obtained by compensating the current obtained from the power source line 1s with the compensating current Iw is detected as the load current It in the case where the negative phase connection is obtained.

The inverter substrate 100A may include a current detector 3r detecting a load current Ir flowing in the input end 2r or a current detector detecting a load current Is flowing in the input end 2s. The phase in which the current detector is provided may be included in the two phases in which the voltage detectors are provided, or needs not be included.

The active filter 200A is a parallel type active filter and includes an inverter 21 and a capacitor 22. The inverter 21 outputs the compensating currents Iu, Iv, and Iw to maintain the voltage supported by the capacitor 22 at a voltage Vdc.

The active filter 200A also includes current detectors 23u and 23w, a voltage detector 24, and an active filter controller 27. The current detectors 23u and 23w detect the compensating currents Iu and Iw, respectively. The voltage detector 24 detects the voltage Vdc. The active filter controller 27 outputs a drive signal Ga.

The compensating currents Iu, Iv, and Iw are obtained by driving the inverter 21 by the drive signal Ga on the basis of the load current It and the line voltage Vrs. The drive signal Ga is generated on the basis of the line voltage Vrs, the load current It, and the compensating currents Iu and Iw (in particular, these values: the same applies hereinafter) obtained from the inverter substrate 100A or further on the basis of the load current Ir. Since the generation itself of such a drive signal Ga in the parallel type active filter can be achieved by a known technique, the description thereof is omitted here.

The active filter 200A also includes an interconnected reactor 26. The interconnected reactor 26 is achieved by reactors for three phases, and the compensating currents Iu, Iv, and Iw are supplied from the inverter 21 to the output connection unit 25 via the interconnected reactor 26.

Constituent elements included in the active filter 200A may be integrally provided in one substrate.

All or part of various procedures executed by the inverter controller 7 and the active filter controller 27 or various means or various functions achieved by them may be achieved by hardware.

For example, both the inverter controller 7 and the active filter controller 27 can include a microcomputer and a storage device. The microcomputer executes each processing step (in other words, procedure) described in a program. The storage device described above can be made of one or a plurality of various storage devices such as a ROM (Read Only Memory), a RAM (Random Access Memory), and a rewritable non-volatile memory (EPROM (Erasable Programmable ROM)), for example. The storage device stores various pieces of information or data, and so on, stores a program executed by the microcomputer, and supplies a workspace for executing the program. The microcomputer may be deemed to function as various means corresponding to each processing step described in the program, or may also be deemed to achieve various functions corresponding to each processing step.

### <Determination of Connection Order>

Described hereinafter is a method of determining which of the positive phase connection or the negative phase connection occurs. The determination needs to be performed only when the active filter 200A is newly disposed in a state where the three-phase power source 1 and the inverter substrate 100A are already connected to each other.

As described above, the operation of the inverter substrate 100A itself does not differ in the positive phase connection or the negative phase connection. However, when the active filter 200A is newly disposed, the output terminals 25r, 25s, and 25t of the active filter 200A are not directly connected to the power source lines 1r, 1s, and It but connected to the input terminals 5r, 5s, and 5t, respectively. Thus, when the input terminals 5r, 5s, and 5t cause the negative phase connection, the output terminals 25r, 25s, and 25t are connected to the power source lines 1r, 1t, and 1s, respectively (refer to Fig. 2).

Accordingly, waveforms of the compensating currents Iu, Iv, and Iw are different in the case where the positive phase connection is obtained from the case where the negative phase connection is obtained. Specifically, the waveforms of the compensating currents Iu, Iv, and Iw in the case where the negative phase connection is obtained should be the same as the waveforms of the compensating currents Iu, Iw, and Iv in the case where the positive phase connection is obtained, respectively.

The active filter 200A can control the appropriate output of the compensating currents Iu, Iv, and Iw in any of the cases where the positive phase connection is obtained and the negative phase connection is obtained. Specifically, the compensating currents Iv and Iw only need to be replaced with each other depending on the case where the positive phase connection is obtained or the negative phase connection is obtained. Patent Document 1 discloses that such a replacement is achieved by a delay of a phase of a compensating current, for example.

Accordingly, once it is determined whether the positive phase connection is obtained or the negative phase connection is obtained, the active filter 200A operates under control of outputting the compensating currents Iu, Iv, and Iw appropriate for each connection. That is to say, the determination needs to be performed only once when the active filter 200A is disposed. The reason is that after the active filter 200A is disposed and the output terminals 25r, 25s, and 25t and the input terminals 5r, 5s, and 5t are connected to each other, the connection needs not be changed, and the connection is therefore maintained.

It is determined which of the positive phase connection or the negative phase connection is obtained on the basis of the line voltage Vrs or a phase voltage Vrn described below and the load current It. A specific method of determination is individually described hereinafter. In the following description, an r-phase, an s-phase, and a t-phase may be circularly replaced with each other in terms of symmetry of the three phases.

### (Determination Method 1)

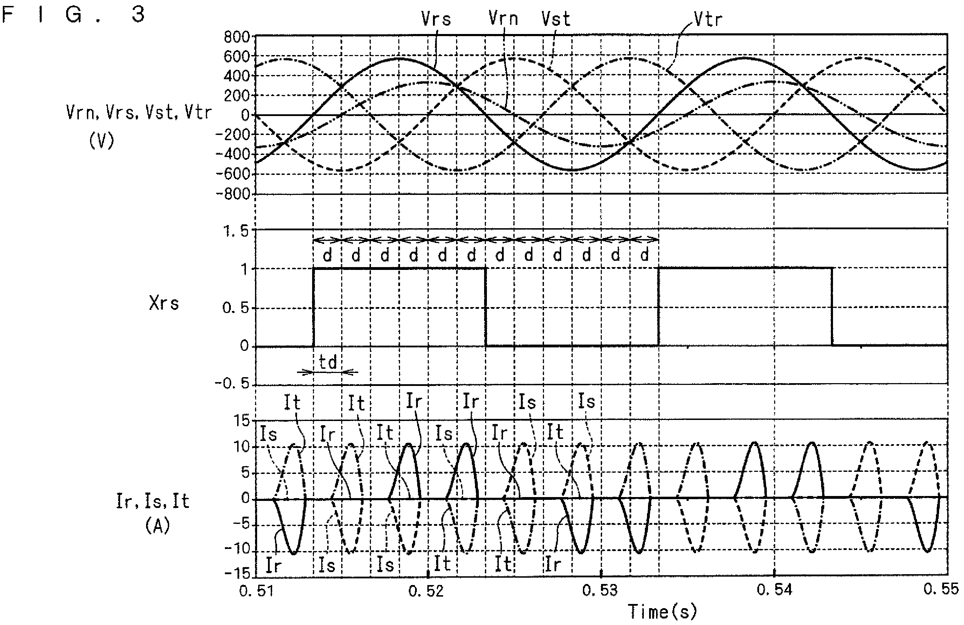

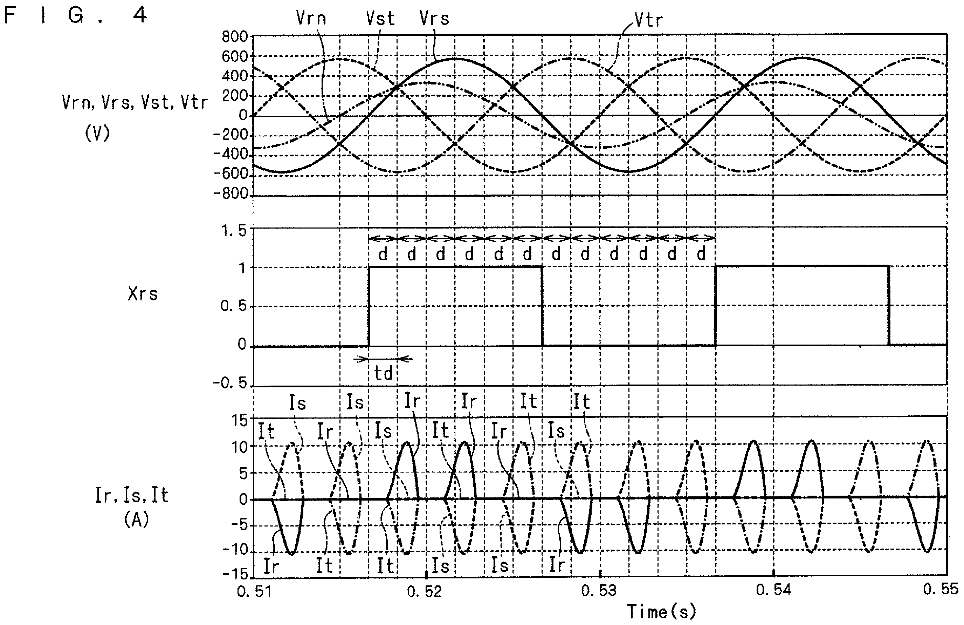

Fig. 3 and Fig. 4 are graphs illustrating various amounts in the case where the positive phase connection is obtained and the case where the negative phase connection is obtained, respectively. Specifically, the various amounts herein indicate line voltages Vrs, Vst, and Vtr, a zero cross signal Xrs, and load currents Ir, Is, and It. The phase voltage Vrn is also described in Fig. 3 and Fig. 4.

The zero cross signal Xrs is a signal activated when a sign of the line voltage Vrs is switched from negative to positive (the voltage Vrs is increasing) and inactivated when the sign of the line voltage Vrs is switched from positive to negative (the voltage Vrs is decreasing). It is ideal that the zero cross signal Xrs is activated/inactivated when the line voltage Vrs takes value zero. In Fig. 3 and Fig. 4, the activation and inactivation of the zero cross signal Xrs are indicated by values 1 and 0, respectively. The zero cross signal Xrs can be generated in the active filter controller 27 on the basis of the line voltage Vrs, or may also be generated in the voltage detector 8 (refer to "Modification 1." hereinafter).

As described in Fig. 1, the voltage detector 8 measures the voltage between the input terminals 5r and 5s. Thus, the line voltage Vrs is the voltage of the AC voltage Vr based on the AC voltage Vs in Fig. 3, and is the voltage of the AC voltage Vr based on the AC voltage Vt in Fig. 4. Similarly, in Fig. 3, the line voltage Vst is the voltage of the AC voltage Vs based on the AC voltage Vt, and the line voltage Vtr is the voltage of the AC voltage Vt based on the AC voltage Vr. In Fig. 4, the line voltage Vst is the voltage of the AC voltage Vt based on the AC voltage Vs, and the line voltage Vtr is the voltage of the AC voltage Vs based on the AC voltage Vr.

That is to say, all of the line voltages Vrs, Vst, and Vtr in Fig. 4 coincide with values obtained by multiplying the line voltages Vtr, Vst, and Vrs in Fig. 3 by a value (-1).

The line voltages Vst and Vtr are not detected and used in the description of this operation, but are described for easy understanding of the relationship of the line voltages described above.

The power source current flowing in the power source lines 1r, 1s, and 1t is influenced by the compensating currents Iu, Iv, and Iw, and the load currents Ir, Is, and It themselves are not influenced by the compensating currents Iu, Iv, and Iw. Thus, the load currents Ir, Is, and It in Fig. 4 coincide with the load currents Ir, It, and Is in Fig. 3. However, in any of the cases, the load current Is can be calculated from the load currents Ir and It (∵ Ir+Is+It=0)

A determination described below is performed using the condition where the line voltage Vrs and the load voltage It are different as described above depending on which of the positive phase connection or the negative phase connection is obtained.
(i-1) Detected is the load current It at a point of time after a lapse of time td from a point of time when the line voltage Vrs increases to take the value zero. The time td is 1/12 times a cycle of the line voltage Vrs or a time of 11/12 times the cycle of the line voltage Vrs. The cycle described above can be easily calculated from a time-dependent change of the line voltage Vrs, and also coincides with any of cycles of the three-phase AC voltages Vr, Vs, and Vt. In each of Fig. 3 and Fig. 4, 1/12 times the cycle described above is indicated by a time d and a case of td = d is illustrated as an example. Needless to say, a case of td = 11·d may be also applied.
(ii-1) When the load current It detected in the above (i-1) is larger than a positive first threshold value, it is determined that the positive phase connection is obtained. When the load current It detected in the above (i-1) is smaller than a negative second threshold value, it is determined that the negative phase connection is obtained. The reason is that, as described above, the detection of the load current It in the case where the negative phase connection is obtained indicates the detection of the load current Is in the case where the positive phase connection is obtained.

Alternatively, a determination described below is performed:
(i-2) 5/12 times the cycle described above (td = 5·d) or a time of 7/12 times the cycle (td = 7·d) are adopted as the time td, and the load current It is detected in the manner similar to the above (i-1); and
(ii-2) when the load current It detected in the above (i-2) is larger than a positive first threshold value, it is determined that the negative phase connection is obtained. When the load current It detected in the above (i-2) is smaller than a negative second threshold value, it is determined that the positive phase connection is obtained.

In this manner, according to the determination method 1, the abnormality in the phase order can be detected with a simple configuration.

Herein, not only a predetermined constant number is used as each of the first threshold value and the second threshold value, but also an average value of the load currents It may be applied to one of the threshold values or both of them. The determination and the calculation described above are executed using a known technique in the active filter controller 27.

When adopted as a point of time when the line voltage Vrs takes the value zero in the above (i-1) and (i-2) is a point of time when the zero cross signal Xrs enters the inactive state from the active state (that is to say, a point of time when the line voltage Vrs decreases to take the value zero), the determination result of the above (ii-1) and (ii-2) is reversed (refer to Fig. 3 and Fig. 4).

When the load current Ir is detected, the positive phase connection and the negative phase connection can be determined in accordance with the determination described below:
detected is the load current Ir at the point of time after the lapse of time td after the line voltage Vrs takes the value zero (herein, the point of time when the zero cross signal Xrs enters the active state from the inactive state);
in the case where the time td is 1/12 times the cycle described above (td = d), it is determined that the negative phase connection is obtained when the detected load current Ir is larger than a positive threshold value, and it is determined that the positive phase connection is obtained when the detected load current Ir is smaller than the positive threshold value;
in the case where the time td is 5/12 times the cycle described above (td = 5·d), it is determined that the positive phase connection is obtained when the detected load current Ir is larger than a positive threshold value, and it is determined that the negative phase connection is obtained when the detected load current Ir is smaller than the positive threshold value;
in the case where the time td is 7/12 times the cycle described above (td = 7·d), it is determined that the positive phase connection is obtained when the detected load current Ir is larger than a negative threshold value, and it is determined that the negative phase connection is obtained when the detected load current Ir is smaller than the negative threshold value; and
in the case where the time td is 11/12 times the cycle described above (td = 11· d), it is determined that the negative phase connection is obtained when the detected load current Ir is larger than a negative threshold value, and it is determined that the positive phase connection is obtained when the detected load current Ir is smaller than the negative threshold value.

When adopted is the point of time when the zero cross signal Xrs enters the inactive state from the active state, the determination result described above is reversed. Similarly, also when the load current Is is detected, it is determined which of the positive phase connection or the negative phase connection is obtained.

From the above, it can be determined which of the positive phase connection or the negative phase connection is obtained by detecting the load current at a specific point of time and comparing a value of the load current with at least one threshold value.

The cycles of the line voltages Vrs, Vst, and Vtr are the same as each other in both the positive phase connection and the negative phase connection, and phases are shifted by 4/12 times the cycle. By integral multiple of the time of 4/12 times the cycle, both the time of 1/12 times and 5/12 times the cycle are, as well as the time of 7/12 times and 11/12 times the cycle, different from each other.

Thus, the point of time after a lapse of time of 1/12, 5/12 7/12, and 11/12 times the cycle from the point of time when the line voltage Vrs takes the value zero is one of the points of time after a lapse of time of 1/12, 5/12, 7/12, and 11/12 times the cycle from the point of time when the line voltage Vst takes the value zero, and is one of the points of time after a lapse of time of 1/12, 5/12 7/12, and 11/12 times the cycle from the point of time when the line voltage Vtr takes the value zero.

Thus, the specific point of time described above is deemed to be the point of time after the lapse of time of N/12 times the cycle of the line voltage (N=1, 5, 7, or 11) from the point of time when the line voltage between any of the two phases takes the value zero.

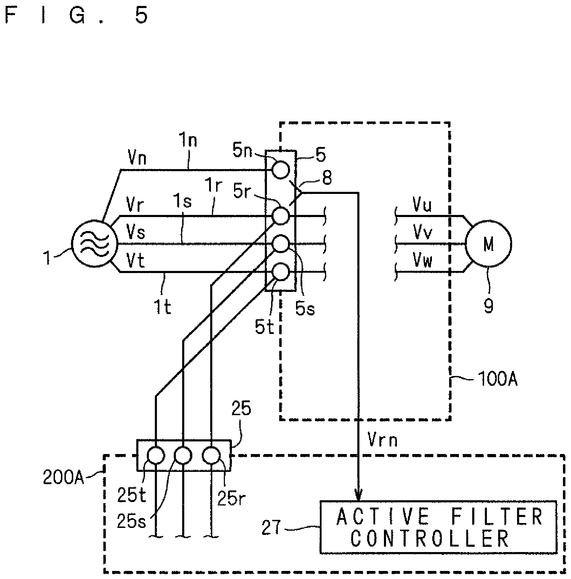

Fig. 5 is a circuit diagram partially illustrating a case where the three-phase power source 1 is a three-phase four-wire type that also outputs neutral-point potential Vn. A part omitted in Fig. 5 is the same as that of Fig. 1. The input connection unit 5 further has a neutral-point input terminal 5n receiving the neutral-point potential Vn, and the voltage detector 8 measures the phase voltage Vrn as the AC voltage Vr based on the neutral-point input terminal 5n.

In the case of the positive phase connection, the point of time when the phase voltage Vrn takes zero in being directed from the negative state to the positive state (the voltage Vrn is increasing) is delayed by the time d of 1/12 times the cycle described above from the point of time when the line voltage Vrs takes zero in being directed from the negative state to the positive state (the voltage Vrs is increasing). In the case of the negative phase connection, the point of time when the phase voltage Vrn takes zero in being directed from the negative state to the positive state is delayed by the time 11·d of 11/12 times the cycle described above from the point of time when the line voltage Vrs takes zero in being directed from the negative state to the positive state. Thus, it can be determined which of the positive phase connection or the negative phase connection is obtained using the load current detected at the point of time based on the point of time when the phase voltage Vrn takes zero in the manner similar to the determination described above.

Specifically, a determination described below is performed:
(i-3) detected is the load current It at a point of time when the phase voltage Vrn increases to take the value zero; and
(ii-3) when the load current It detected in the above (i-3) is larger than a positive first threshold value, it is determined that the positive phase connection is obtained. When the load current It detected in the above (i-3) is smaller than a negative second threshold value, it is determined that the negative phase connection is obtained.

Alternatively, a determination described below is performed:
(i-4) detected is the load current It at a time after a lapse of time td from a point of time when the phase voltage Vrn increases to take the value zero. The time td is 6/12 times a cycle of the phase voltage Vrn (td = 6·d). The cycle described above can be easily calculated from a time-dependent change of the phase voltage Vrn, and also coincides with any of cycles of the three-phase AC voltages Vr, Vs, and Vt.
(ii-4) when the load current It detected in the above (i-4) is larger than a positive first threshold value, it is determined that the negative phase connection is obtained. When the load current It detected in the above (i-4) is smaller than a negative second threshold value, it is determined that the positive phase connection is obtained.

Alternatively, a determination described below is performed:
(i-5) 2/12 times the cycle described above (td = 2·d) is adopted as the time td, and the load current It is detected in the manner similar to the above (i-4); and
(ii-5) when the load current It detected in the above (i-5) is larger than a negative threshold value, it is determined that the positive phase connection is obtained. When the load current It detected in the above (i-5) is smaller than the threshold value, it is determined that the negative phase connection is obtained.

Alternatively, a determination described below is performed:
(i-6) 4/12 times the cycle described above (td = 4·d) is adopted as the time td, and the load current It is detected in the manner similar to the above (i-4); and
(ii-6) when the load current It detected in the above (i-6) is larger than a negative threshold value, it is determined that the negative phase connection is obtained. When the load current It detected in the above (i-6) is smaller than the threshold value, it is determined that the positive phase connection is obtained.

Alternatively, a determination described below is performed:
(i-7) 8/12 times the cycle described above (td = 8·d) is adopted as the time td, and the load current It is detected in the manner similar to the above (i-4); and
(ii-7) when the load current It detected in the above (i-7) is larger than a positive threshold value, it is determined that the negative phase connection is obtained. When the load current It detected in the above (i-7) is smaller than the threshold value, it is determined that the positive phase connection is obtained.

Alternatively, a determination described below is performed:
(i-8) 10/12 times the cycle described above (td = 10·d) is adopted as the time td, and the load current It is detected in the manner similar to the above (i-4); and
(ii-8) when the load current It detected in the above (i-8) is larger than a positive threshold value, it is determined that the positive phase connection is obtained. When the load current It detected in the above (i-8) is smaller than the threshold value, it is determined that the negative phase connection is obtained.

In a case of adopting the point of time when the phase voltage Vrn decreases to take zero as a base, the determination results of the positive phase connection and the negative phase connection in the above (ii-3) to (ii-8) are reversed.

From the above, it can be determined which of the positive phase connection or the negative phase connection is obtained by determining a specific point of time based on the phase voltage Vrn, detecting the load current at the specific point of time, and comparing a value of the load current with at least one threshold value.

The cycles of the phase voltage Vrn and the phase voltages Vsn and Vtn (not shown) are the same as each other in both the positive phase connection and the negative phase connection, and phases are shifted by 4/12 times the cycle. By integral multiple of the time of 2/12 times the cycle, the times of 2/12, 4/12, 6/12, 8/12, and 10/12 times the cycle are different from each other.

Thus, the point of time when the phase voltage Vrn takes the value zero and the points of time after a lapse of time of 2/12, 4/12, 6/12, 8/12, and 10/12 times the cycle are one of the point of time when the phase voltage Vsn takes the value zero and one of the points of time after the lapse of time of 2/12, 4/12, 6/12, 8/12, and 10/12 times the cycle, and are also one of the point of time when the phase voltage Vtn takes the value zero and the points of time after the lapse of time of 2/12, 4/12, 6/12, 8/12, and 10/12 times the cycle.

Thus, the specific point of time described above is deemed to be a point of time when any of the phase voltages takes the value zero or a point of time after the lapse of time of N/12 times the cycle of the phase voltage (N=2, 4, 6, 8, or 10) from the point of time when any of the phase voltages takes the value zero.

The above configuration enables not only the measurement of the load current It itself but also the determination which of the positive phase connection or the negative phase connection is obtained on ground of an average value of the load current It, or increase and decrease in the load current It.

Detected, for example, is the average value of the load currents It in a period of a length of time d (referred to as "the specific period of time" hereinafter) immediately after a point of time after a lapse of time td from a point of time when the line voltage Vrs increases to take the value zero. Herein, the time td is set so that td = d or td = 11·d is satisfied similarly to (i-1). In the above case, the average value takes a positive value when the positive phase connection is obtained, and takes a negative value when the negative phase connection is obtained. The time td is set so that td = 5·d or td = 7·d is satisfied similarly to (i-2). In the above case, the average value takes a negative value when the positive phase connection is obtained, and takes a positive value when the negative phase connection is obtained.

In the case of adopting the point of time when the line voltage Vrs decreases to take the value zero as the base, these determinations on the positive phase connection/negative phase connection are reversed. The determinations on the positive phase connection/negative phase connection can also be performed when the point of time when the phase voltage Vrn takes the value zero is adopted instead of the point of time when the line voltage Vrs takes the value zero.

Thus, it can be determined which of the positive phase connection or the negative phase connection is obtained by comparing the average value of the currents in the specific period of time described above with at least one threshold value. Similarly, also when the specific point of time is set, and moreover, the specific period of time is set on the basis of the other line voltages Vst and Vtr or the phase voltage Vrn, it can be determined which of the positive phase connection or the negative phase connection is obtained using the average value.

Alternatively considered as the specific period of time is, for example, a period of a length of time d immediately after a point of time when the line voltage Vrs increases to take the value zero or when time td = 10·d has elapsed from the point of time. The load current It in the specific period of time increases when the positive phase connection is obtained, and decreases when the negative phase connection is obtained. Alternatively considered as the specific period of time is, for example, a period of a length of time d immediately after a point of time after a lapse of time td (= 4·d or 6·d) from a point of time when the line voltage Vrs increases to take the value zero. The load current It in the specific period of time decreases when the positive phase connection is obtained, and increases when the negative phase connection is obtained. In the case of adopting the point of time when the line voltage Vrs decreases to take the value zero as the base, these determinations on the positive phase connection/negative phase connection are reversed.

Thus, it can be determined which of the positive phase connection or the negative phase connection is obtained in accordance with the increase and decrease in the current in the specific period of time described above. Similarly, also when the specific point of time is set, and moreover, the specific period of time is set on the basis of the other line voltages Vst and Vtr or the phase voltage Vrn, it can be determined which of the positive phase connection or the negative phase connection is obtained using the increase and decreases.

### (Determination Method 2)

Not only the load current It but also the load current Ir are detected, it is determined which of the positive phase connection or the negative phase connection is obtained in accordance with the determinations described below.

(iii) Detected are the load currents Ir and It at a point of time (a specific point of time) after a lapse of time td from a point of time when the line voltage Vrs takes the value zero (herein, a point of time when the zero cross signal Xrs enters the active state from the inactive state) to obtain the load current Is = -It -Ir.

(iv) A magnitude relationship of the load currents Ir, Is, and It detected and calculated in the above (iii) is determined. When td is set to satisfy td = d and It > Ir > Is is satisfied in (iii), it is determined that the positive phase connection is obtained. When Ir > Is > It is satisfied, it is determined that the negative phase connection is obtained.

In this manner, according to the determination method 2, the abnormality in the phase order can be detected with a simple configuration. Moreover, although an appropriate setting of the various threshold values is desirable for the accurate determination in the determination method 1 that relies on a polarity of the load current It, the determination method 2 that relies on the magnitude relationship between the load currents Ir, It, and Is enables the more accurate determination.

As described above, the load currents Ir, Is, and It in Fig. 4 coincide with the load currents Ir, It, and Is in Fig. 3, respectively, and the point of time of performing the detection of (iii) depends on the line voltage Vrs, thus the magnitude relationship between the load currents in the case where the negative phase connection is obtained is as described above. Needless to say, it can be determined which of the positive phase connection or the negative phase connection is obtained on the basis of the inequality described above only by the magnitude relationship between the load currents It and Ir without calculating the load current Is.

It is alternatively applicable to determine which of the positive phase connection or the negative phase connection is obtained by shifting the phase of the load current It to estimate the load current Ir, without directly detecting the load current Ir, only by the magnitude relationship between the load currents It and Ir. The determination and the calculation described above are executed using a known technique in the active filter controller 27.

When adopted as the point of time when the line voltage Vrs takes the value zero is the point of time when the zero cross signal Xrs enters the inactive state from the active state, the determination result of the above (iv) is reversed (refer to Fig. 3 and Fig. 4).

Also in the determination method 2, in the manner similar to the determination method 1, when the time td is N/12 times the cycle described above (N = 1, 5, 7, or 11), it is determined which of the positive phase connection or the negative phase connection is obtained from the magnitude relationship between the load currents detected at the timing described above.

Alternatively, it may also be determined which of the positive phase connection or the negative phase connection is obtained on the basis of the magnitude relationship between the load currents It and Ir detected at the point of time when the phase voltage Vrn takes the value zero.

When the two-phase load currents Is and It, whose phases are different from the phase corresponding to the phase voltage Vrn, are detected or calculated, it is determined which of the positive phase connection or the negative phase connection is obtained in accordance with the determinations described below.

(iv-1) When adopted as a specific point of time is a point of time when the phase voltage Vrn increases to take the value zero or a point of time after a lapse of time td of 2/12 or 10/12 times the cycle of the phase voltage from the point of time when the phase voltage Vrn increases to take the value zero, it is determined that the positive phase connection is obtained when It > Is is satisfied. When Is > It is satisfied, it is determined that the negative phase connection is obtained.

(iv-2) When adopted as a specific point of time is a point of time after a lapse of time td of 4/12, 6/12, or 8/12 times the cycle of the phase voltage from a point of time when the phase voltage Vrn increases to take the value zero, it is determined that the negative phase connection is obtained when It > Is is satisfied. When Is > It is satisfied, it is determined that the positive phase connection is obtained.

In a case of adopting, as the specific point of time, the point of time when the phase voltage Vrn decreases to take zero as a base, the determination results of the above (iv-1) to (iv-2) are reversed.

### (Determination Method 3)

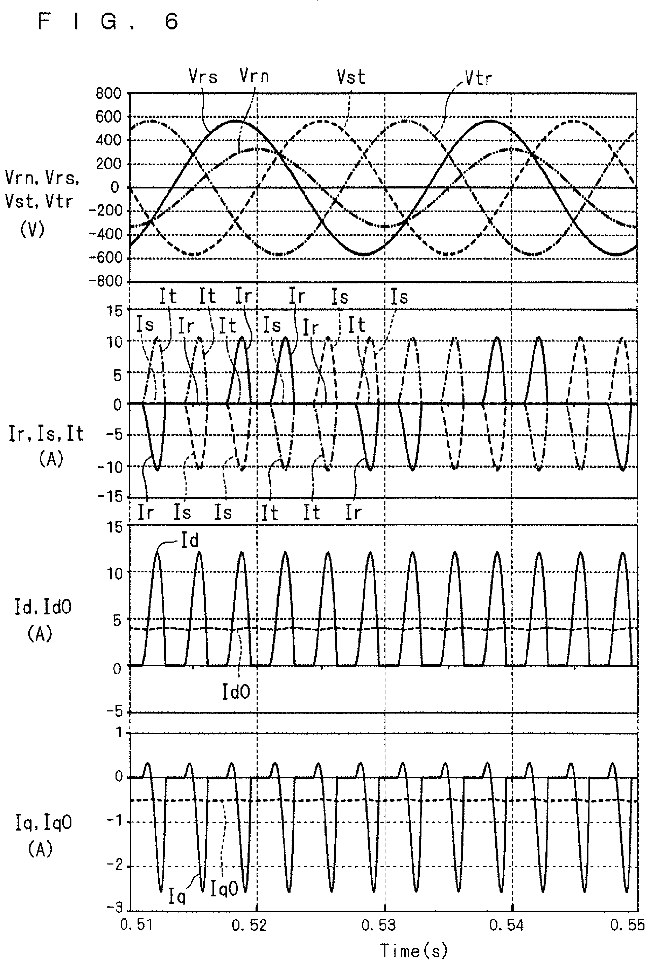

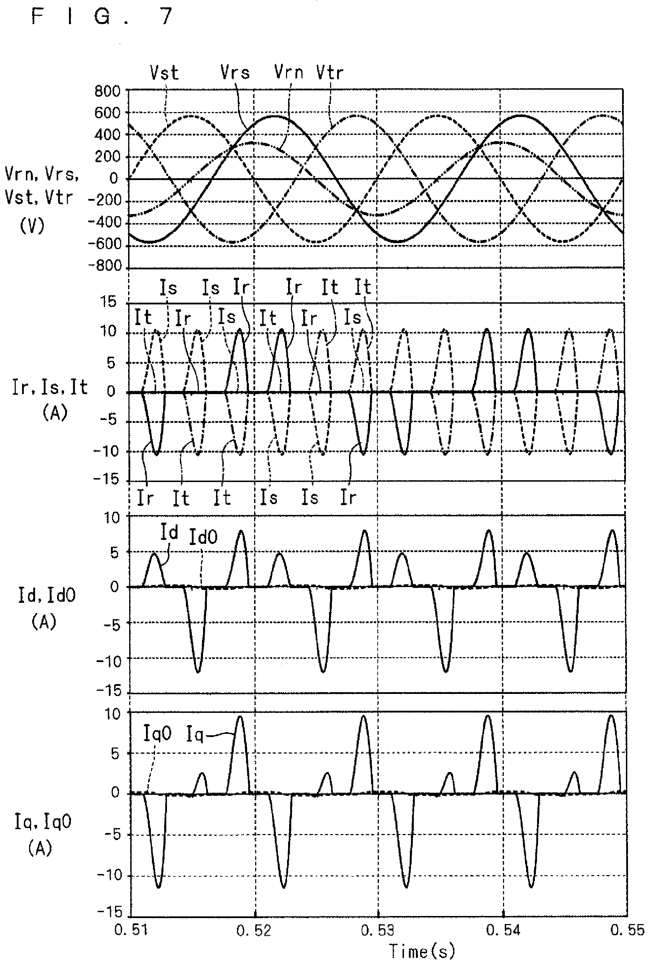

Fig. 6 and Fig. 7 are graphs illustrating various amounts in the case where the positive phase connection is obtained and the case where the negative phase connection is obtained, respectively. Specifically, the various amounts herein indicate line voltages Vrs, Vst, and Vtr, load currents Ir, Is, and It, a d-axis current candidate Id and a DC component thereof (a power source frequency component) Id0, and a q-axis current candidate Iq and a DC component thereof (a power source frequency component) Iq0.

The d-axis current and q-axis current generally indicate a current component synchronized with a periodical variation of the AC voltages Vr, Vs, and Vt of the load currents. The q-axis current is the current component in which the phase is orthogonal to the d-axis current. In this embodiment, the d-axis current candidate Id is obtained in the active filter controller 27 in a manner described below, for example, using a known technique.

(v) An estimated value Φ ^ of a phase Φ of one of the AC voltages Vr, Vs, and Vt is obtained from the line voltage Vrs (or one of the phase voltage);
(vi) a three phase/two phase conversion is performed on the load currents Ir, Is, and It on the basis of the estimated value Φ ^ to obtain the d-axis current candidate Id as the current component having the same phase as the phase of the estimated value Φ ^ .

The q-axis current candidate Iq is obtained from the three phase/two phase conversion of the load currents Ir, Is, and It as the current component in which the phase of the q-axis current candidate Iq is orthogonal to the phase of the d-axis current candidate Id, and is more advanced by 90 degrees, for example.

The stationary phase difference of the estimated value Φ ^ with respect to the AC voltages Vr, Vs, and Vt does not become a problem in obtaining the d-axis current candidate Id. The reason is that the d-axis current candidate Id is synchronized with the periodic variation of the AC voltages Vr, Vs, and Vt.

However, the estimated value Φ ^ is obtained by considering the line voltage Vrs as the value of the AC voltage Vr based on the AC voltage Vs. In other words, the estimated value Φ ^ is synchronized with the phase Φ when the positive phase connection is obtained. However, when the negative phase connection is obtained, the estimated value Φ ^ is not synchronized with the phase Φ, but an advancing direction of the estimated value Φ ^ becomes a lagging direction of the phase Φ.

That is to say, when the positive phase connection is obtained, the estimated value Φ ^ is synchronized with the phase Φ, and the d-axis current candidate Id obtained on the basis of the estimated value Φ ^ is also synchronized with the phase Φ. That is to say, the d-axis current candidate Id is correctly obtained as the d-axis current.

On the other hand, when the negative phase connection is obtained, the estimated value Φ ^ is not synchronized with the phase Φ, and the d-axis current candidate Id obtained on the basis of the estimated value Φ ^ is not also synchronized with the phase Φ. That is to say, the value different from the d-axis current is obtained as the d-axis current candidate Id. The same applies to the q-axis current candidate Iq.

When the rectifier circuit 2 is the diode bridge, a regeneration current does not have an influence on the load current. Thus, the d-axis current does not the negative value (refer to Fig. 6). That is to say, when the positive phase connection is obtained, the d-axis current candidate Id does not take the negative value. In contrast, when the negative phase connection is obtained, the estimated value Φ ^ is not synchronized with the phase Φ, the d-axis current candidate Id takes the negative value in a half cycle of the line voltage Vrs. Fig. 7 illustrates a case where the d-axis current candidate Id reaches -10(A) as an example. Thus, the determination described below is adopted.

(vii) When there is no variation of the polarity (positive and negative) of the d-axis current candidate Id in the half cycle of the line voltage Vrs, it is determined that the positive phase connection is obtained, and when there is the variation, it is determined that the negative phase connection is obtained.

In this manner, according to the determination method 3, the abnormality in the phase order can be detected with a simple configuration.

### (Determination Method 4)

The detection of the variation of the polarity of the d-axis current candidate Id is equivalent to the comparison between the d-axis current candidate Id and the value zero, thereby being heavily influenced by an error in a calculation of the estimated value Φ ^ and a calculation of the three phase/two phase conversion. Thus, it is also applicable that the DC component Id0 of the d-axis current candidate Id is obtained to compare the DC component Id0 with a predetermined value. That is to say, the determination described below is adopted.

(viii-1) When the DC component Id0 exceeds a positive predetermined value, it is determined that the positive phase connection is obtained, and otherwise, it is determined that the negative phase connection is obtained.

In Fig. 6 which illustrates the case where the positive phase connection is obtained, the DC component Id0 is approximately 4(A), however, in Fig. 7 which illustrates the case where the negative phase connection is obtained, the DC component Id0 is almost 0(A).

Similarly, it is also applicable that the DC component Iq0 of the q-axis current candidate Iq is obtained to compare the DC component Iq0 with a predetermined value. In Fig. 6 which illustrates the case where the positive phase connection is obtained, the DC component Iq0 is approximately -0.5(A), however, in Fig. 7 which illustrates the case where the negative phase connection is obtained, the DC component Iq0 is almost 0(A). Thus, the determination described below is adopted.

(viii-2) When the DC component Iq0 exceeds a negative predetermined value, it is determined that the negative phase connection is obtained, and otherwise, it is determined that the positive phase connection is obtained.

In this manner, according to the determination method 4, the abnormality in the phase order can be detected with a simple configuration. Furthermore, the threshold value for the determination can be set more easily than the determination method 3 relying on the determination of the polarity. In other words, the accurate determination can be performed by the determination method 4 more easily than the determination method 3.

Obtainment of the d-axis current candidate Id and the DC component Id0 thereof, the q-axis current candidate Iq and the DC component Iq0 thereof, and the determination described above is executed using a known technique in the active filter controller 27.

### <Advantage of First Embodiment>

The determination methods 1 to 4 described above, in the inverter substrate 100A expected are,
(a) detecting the load current It flowing in the input end 2t connected to the input terminal 5t by the current detector 3t (and /or detecting the load current Ir flowing in the input end 2r connected to the input terminal 5r by the current detector 3r),
(b) detecting the line voltage Vrs as the voltage of the input terminal 5r based on the potential of the input terminal 5s (or the phase voltage Vrn as the voltage of the input terminal 5r based on the potential of the neutral-point input terminal 5n) by the voltage detector 8, and
(c) obtaining the detection values of the load current It (and/or the load current Ir) and the line voltage Vrs (or the phase voltage Vrn) by the active filter controller 27.

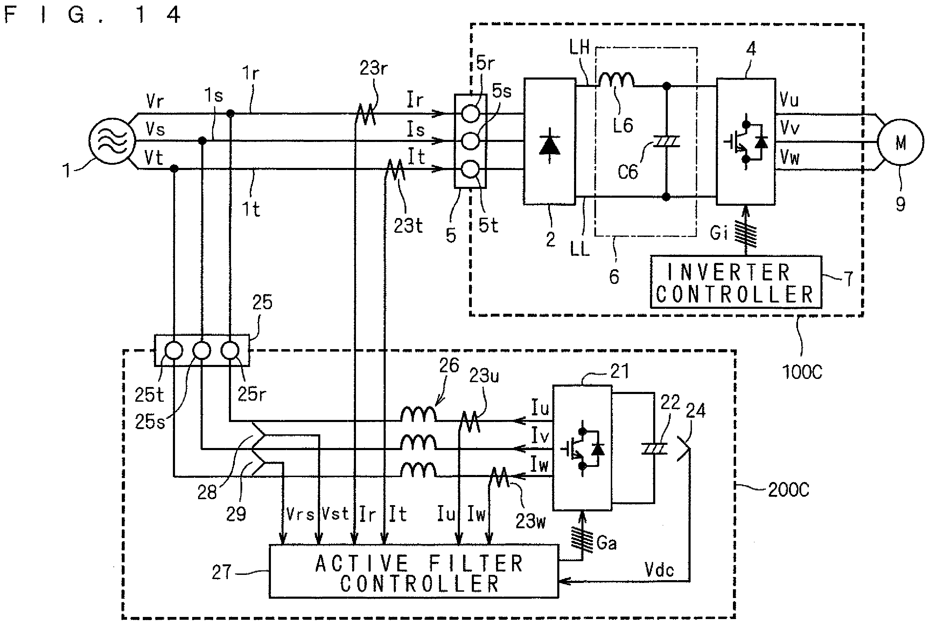

Fig. 14 is a circuit diagram illustrating a comparison example compared with the first embodiment. In Fig. 14, an inverter substrate 100C has a configuration that the current detectors 3t and 3r and the voltage detector 8 are removed from the inverter substrate 100A of the first embodiment. An active filter 200C has a configuration that the voltage detectors 28 and 29 are added to the active filter 200A of the first embodiment. The voltage detectors 28 and 29 detect line voltages being different from each other.

In Fig. 14, the output terminals 25r, 25s, and 25t of the active filter 200C are connected to the power source lines 1r, 1s, and It, respectively. The input terminals 5r, 5s, and 5t of the inverter substrate 100C are also connected to the power source lines 1r, 1s, and It, respectively. That is to say, Fig. 14 illustrates the case where the positive phase connection is obtained. Current detectors 23r and 23t are provided in the power source lines 1r and It, respectively, and two-phase parts of load currents flowing into the input terminals 5r, 5s, and 5t are detected. Such a configuration is publicly known in Patent Document 1, for example.

However, when the active filter 200C is subsequently connected to the power source lines 1r, 1s, and 1t to which the inverter substrate 100C is already connected, there may be an error that the current detectors 23r and 23t are not correctly provided in the power source lines 1r and 1t even in a case where the output terminals 25r, 25s, and 25t are correctly connected to the power source lines 1r, 1s, and 1t. In other words, when the active filter 200C is installed on-the-spot, there may be an error that an electrical positional relationship with the power source lines 1r, 1s, and 1t is not consistent between the current detectors 23r and 23t and the voltage detectors 28 and 29.

In such a case, the two different line voltages are required as described above when the active filter controller 27 determines which of the positive phase connection or the negative phase connection is obtained. That is to say, the two voltage detectors 28 and 29 are necessary. Moreover, the determination processing thereof is cumbersome.

In contrast, according to the first embodiment, the connection relationship between the input terminals 5t, 5s, and 5t, the input ends 2r, 2s, and 2t, the voltage detector 8, and the current detector 3t (or further the current detector 3r) is fixed inside the inverter substrate 100A. Thus, even when the active filter 200A is newly connected, the electrical positional relationship with the power source lines 1r, 1s, and 1t between the current detector 8 and the current detector 3t remains consistent.

Accordingly, abnormality in the phase order is detected with a simpler configuration in the first embodiment, as is the case for the determination methods 1 to 4, than the conventional techniques (for example, the techniques introduced in Patent Documents 1 and 2) of the comparison example illustrated in Fig. 14.

### <Open Phase Determination>

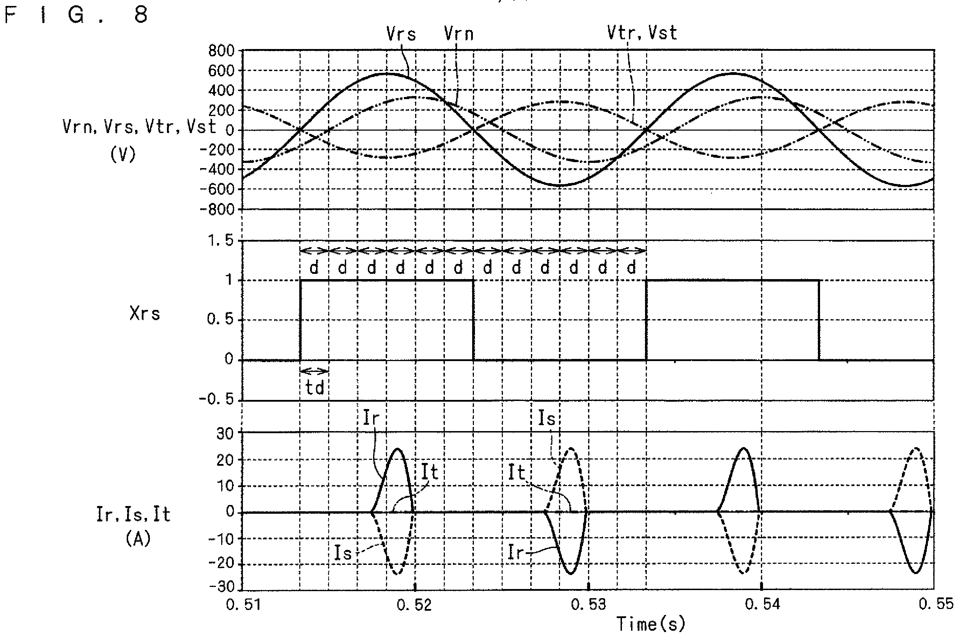

The open phase in the power source lines 1r, 1s, and 1t can also be determined in the first embodiment 1. Fig. 8 is a graph illustrating various amounts in a case where an earth fault occurs in the power source line It and an open phase occurs. Specifically, the various amounts herein indicate the line voltages Vrs, Vst, and Vtr, the zero cross signal Xrs, and the load currents Ir, Is, and It. There is a relationship of Vst = Vtr = (-1/2)·Vrs due to the open phase described above.

In such a case, detected is the load current It at the point of time after the lapse of time td (in Fig. 8 illustrates the case of td = d as an example) of N/12 times (N = 1, 5, 7, or 11) the cycle of the AC voltages Vr, Vs, and Vt from the point of time when the line voltage Vrs takes the value zero (regardless of whether the point of time when the zero cross signal Xrs enters the active state from the inactive state or enters the inactive state from the active state), and when a magnitude (an absolute value) of the load current It is smaller than the predetermined value, it can be determined that the open phase occurs in the input terminal 5t. In contrast, when the magnitude is equal to or larger than the predetermined value, it can be determined that the open phase does not occur. Thus, the presence or absence of the open phase in the input terminal 5t is determined.

The determination does not depend on the state where the positive phase connection is obtained or the negative phase connection is obtained. The reason is that when the open phase occurs, all of the load currents Ir, Is, and It ideally becomes zero at this time.

Similarly, also when the load current It at the specific point of time being set based on the phase voltage Vrn is detected, the presence or absence of the open phase is determined in the similar manner. The specific point of time is also the point of time when the phase voltage Vrn takes the value zero (any of the point of time when the phase voltage Vrn increases to take the value zero or decreases to take the value zero).

Differing from the case of determining which of the positive phase connection of the negative phase connection is obtained, the processing of determining the presence or absence of the open phase is ideally performed every time when the operation of the active filter 200A is started. The connection relationship is not changed after the installation of the active filter 200A, however, there is a possibility that the open phase occurs even after the installation due to a defect of a power source system or facility. It is preferable that the open phase determination is performed every time when the operation of the active filter 200A is started to avoid an abnormal operation of the active filter 200A and further the inverter substrate 100A.

The timing capable of performing the open phase determination further increases when it is already known which of the positive phase connection and the negative phase connection is obtained. Specifically, when the positive phase connection is obtained, with reference to Fig. 3, it can be determined that the open phase occurs in the input terminal 5t when the absolute value of the load current It at a point of time when the phase voltage Vrn takes the value zero or a point of time after the lapse of time td (= 4·d, 6·d, or 10·d) from the point of time is smaller than the predetermined value. It can be determined that the open phase does not occur in the input terminal 5t when the absolute value is equal to or larger than the predetermined value. When the negative phase connection is obtained, with reference to Fig. 4, it can be determined that the open phase occurs in the input terminal 5t when the absolute value of the load current It at a point of time when the phase voltage Vrn takes the value zero or a point of time after the lapse of time td (= 2·d, 6·d, or 8·d) from the point of time is smaller than the predetermined value. It can be determined that the open phase does not occur in the input terminal 5t when the absolute value is equal to or larger than the predetermined value.

### Second embodiment.

### <Configuration>

The active filter can be mounted on the inverter substrate 100C described in the first embodiment. The above configuration is appropriate for a so-called electrolytic capacitor-less inverter in which the smoothing function is omitted from the capacitor C6 included in the smoothing filter 6. In the electrolytic capacitor-less inverter, the capacitor C6 only needs to remove a switching noise of the inverter 4, thus the reduced electrostatic capacitance is sufficient. The electrolytic capacitor can be thereby eliminated from the smoothing filter 6.

In the electrolytic capacitor-less inverter, a control is performed on a premise that the DC voltage supplied to the DC buses LH and LL changes integral multiple of the power source voltage. Thus, when the active filter is applied to the electrolytic capacitor-less inverter, information on the phases of the three-phase AC voltages Vr, Vs, and Vt is necessary for the inverter controller 7 with regard to the first embodiment.

Thus, the present embodiment describes an inverter substrate in a case where (the information on the value of) the line voltage Vrs is supplied not only to the active filter controller 27 but also to the inverter controller 7 to reduce the capacitor C6.

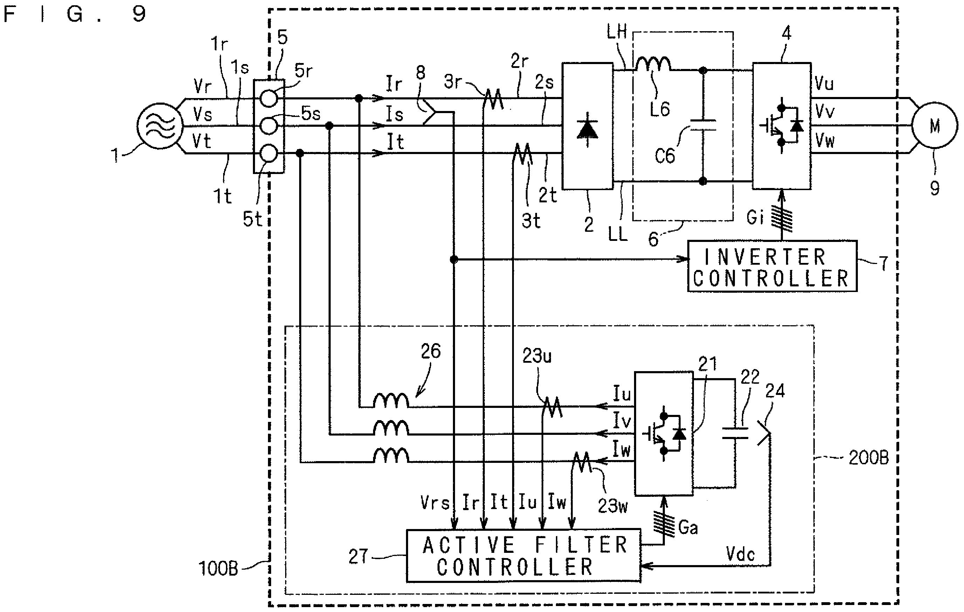

Fig. 9 is a circuit diagram illustrating a configuration of an inverter substrate 100B according to the second embodiment and a connection relationship with the other constituent element connected to the inverter substrate 100B.

The inverter substrate 100B includes an active filter 200B in addition to the inverter substrate 100A described in the first embodiment 1. However, a normal symbol of capacitor is applied for the representation of the capacitor C6 to indicate that the capacitor C6 is not the electrolytic capacitor.

The active filter 200B has a configuration that the output connection unit 25 is omitted from the active filter 200A described in the first embodiment 1. However, the capacitor 22 has a small capacity to be consistent with the capacitor C6, and is indicated by a normal symbol of capacitor.

An end portion of the interconnected reactor 26 on a side opposite to the inverter 21 is connected between the input connector 5 and the rectifier circuit 2. Accordingly, the compensating current Iu is supplied to a wire connecting the input terminal 5r and the input end 2r, the compensating current Iv is supplied to a wire connecting the input terminal 5s and the input end 2s, and the compensating current Iw is supplied to a wire connecting the input terminal 5t and the input end 2t.

However, when the current detector 3r is provided on a side closer to the input terminal 5t (a side farther from the input end 2t) with respect to the current detector 3t, the interconnected reactor 26 is connected to a side closer to the input terminal 5r with respect to the current detector 3r (a side farther from the input end 2r). This is the connection relationship for the electrode detector 3t detecting the load current It or moreover for the current detector 3r detecting the load current Ir, respectively.

Alternatively, the interconnected reactor 26 may be connected to the input connection unit 5 in the inverter substrate 100B.

The inverter controller 7 generates the drive signal Gi also based on the line voltage Vrs. Since the generation can be achieved by a known method of the electrolytic capacitor-less inverter, the detail description thereof is omitted here.

Since the inverter substrate 100B maintains the connection relationship between the inverter substrate 100A and the active filter 200A in the first embodiment, it can be determined, in the manner similar to the first embodiment, which of the positive phase connection or the negative phase connection is obtained and whether or not the open phase occurs.

However, when imbalance occurs in the three-phase power source 1, the second embodiment has an advantage that the determination is accurately performed compared with the first embodiment. More specifically, when the electrolytic capacitor-less inverter is constituted with the reduced capacitor C6 regardless of whether the active filter 200B is provided in the inverter substrate 100B or individually provided, the determination which of the positive phase connection and a negative phase connection is obtained is accurately performed as described below.

### <Operation>

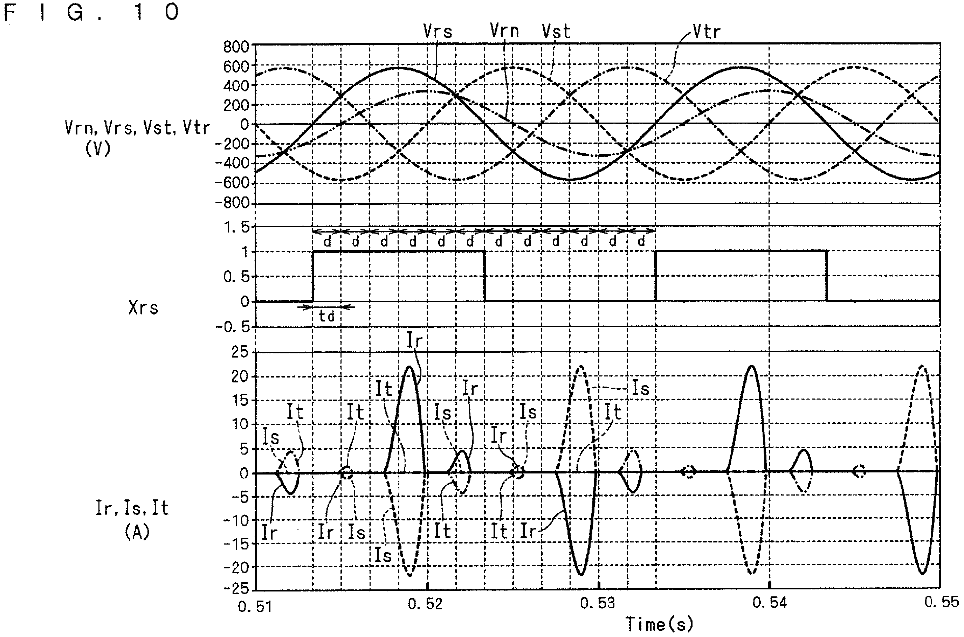

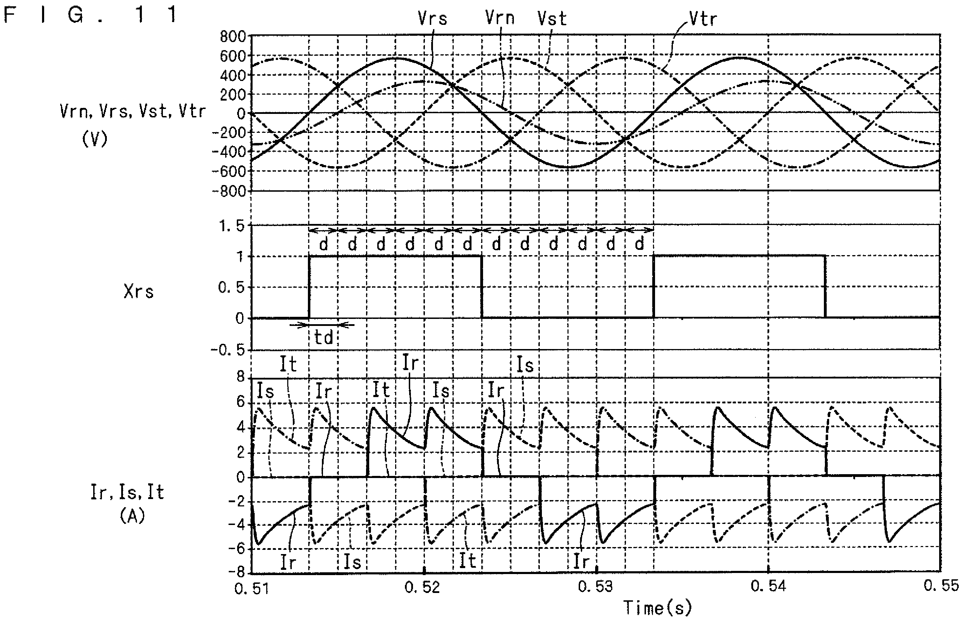

The advantage in the present embodiment is described hereinafter by comparison with the first embodiment. Both Fig. 10 and Fig. 11 are graphs each illustrating various amounts in a case where a positive phase connection is obtained. Specifically, the various amounts herein indicate the line voltages Vrs, Vst, and Vtr, the phase voltage Vrn, the zero cross signal Xrs, and the load currents Ir, Is, and It. Both graphs illustrate a case of td = d.

However, although not clear from the graphs, in both Fig. 10 and Fig. 11, the line voltages Vrs, Vst, and Vtr are distorted in shape with respect to the waveforms illustrated in Fig. 3. Specifically described as an example herein are the line voltages Vrs, Vst, and Vtr in a case where the three-phase AC voltages Vr, Vs, and Vt become unbalanced by +3%, 0%, and -3%, respectively.

Fig. 10 and Fig. 11 illustrate cases where the capacitors C6 are 2000µF and 20µF, respectively. In Fig. 10, the magnitudes (the absolute values) of all of the load currents Ir, Is, and It are significantly large at the specific point of time at which the load current It is detected due to the imbalance of the AC voltages Vr, Vs, and Vt. The determination by the determination method 1 is accordingly difficult, so that the determination method 2 which requires both the current detectors 3r and 3t is adopted to perform the accurate determination.

In contrast, in Fig. 11, the magnitudes of all of the load currents Ir, Is, and It widely change by six times the cycles of the AC voltages Vr, Vs, and Vt, but do not become significantly small even when there is the imbalance of the AC voltages Vr, Vs, and Vt. Thus, the polarity of the load current It can be easily determined at the specific point of time at which the load current It is detected, thus it can be easily determined which of the positive phase connection and the negative phase connection is obtained. It is also preferable from a standpoint that the determination method 1, which does not need the current detector 3r, can be adopted.

Resistance to such a power source imbalance is not limited to a method referred to as the electrolytic capacitor-less inverter. When a variation in a rectified voltage with a six-fold cycle in one cycle of the power source voltage, that is a so-called six-pulse rectification (120 degrees conduction), is achieved, the effect described above is obtained. For example, when the rectifier circuit 2 is made up of a diode bridge for full-wave rectification and the electrostatic capacitance of the capacitor C6 is reduced, the six-pulse rectification is achieved. When the efficiency in the inverter 4 is ignored, the drive signal Gi may be generated without considering the variation in the rectified voltage being input to the inverter 4.

Needless to say, even when the electrolytic capacitor-less inverter is not constituted, the active filter 200B can be included in the inverter substrate 100B without supplying the line voltage Vrs to the inverter controller 7.

### Modification 1.

The second embodiment illustrates a case of using the line voltage Vrs not only in the active filter controller 27 but also in the inverter controller 7 as an example. In the above case, one voltage detector 8 can double as the function of supplying the zero cross signal Xrs to the active filter controller 27 and the function of supplying the zero cross signal Xrs to the inverter controller 7.

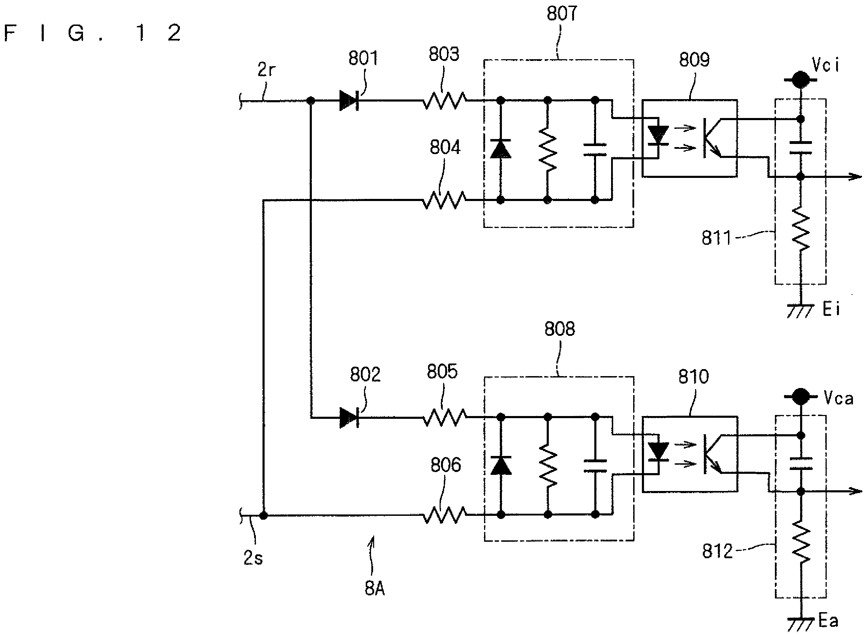

Fig. 12 is a circuit diagram illustrating a configuration of a zero cross signal generator 8A as an example. The zero cross signal generator 8A can be adopted as the voltage detector 8.

The zero cross signal generator 8A includes diodes 801 and 802, resistors 803, 804, 805, and 806, voltage current conversion circuits 807 and 808, insulating units 809 and 810, and voltage output circuits 811 and 812.

For example, the voltage current conversion circuits 807 and 808 are made up of a parallel connection of a diode, a resistor, and a capacitor. For example, a photo coupler can be adopted to the insulating units 809 and 810. For example, the voltage output circuit 811 can be made up of a resistor and a capacitor series-connected between an operation power source Vci of the inverter controller 7 and a ground Ei. For example, the voltage output circuit 812 can be made up of a resistor and a capacitor series-connected between an operation power source Vca of the active filter controller 27 and a ground Ea.

The diode 801, the resistors 803 and 804, and the voltage current conversion circuit 807 are series-connected between the input ends 2r and 2s (or between the input terminals 5r and 5s). The voltage current conversion circuit 807 receives the DC voltage which is generated when the line voltage Vrs is rectified in the diode 801 and then divided in the resistors 803 and 804, and flows the current relying on the DC voltage into an input side of the insulating unit 809. The insulating unit 809 flows the current based on the current flowing in the input side to an output side while electrically insulting the current from the input side. When the current equal to or larger than a threshold value flows into the input side of the insulating unit 809, a transistor at the output side of the insulating unit 809 is turned on. The voltage output circuit 811 thereby outputs the voltage of the operation power source Vci. When the transistor is turned off, the capacitor is charged, and potential of the ground Ei is output from the voltage output circuit 811. The zero cross signal Xrs in accordance with the polarity (positive and negative) of the line voltage Vrs is thereby obtained. Specifically, the voltage of the operation power source Vci and the potential of the ground Ei is served as the zero cross signal Xrs in the operation of the inverter controller 7.

The voltage current conversion circuit 808 receives the DC voltage which is generated when the line voltage Vrs is rectified in the diode 802 and then divided in the resistors 805 and 806, and flows the current relying on the DC voltage into an input side of the insulating unit 810. The insulating unit 810 flows the current based on the current flowing in the input side to an output side while electrically insulting the current from the input side. When the current equal to or larger than a threshold value flows into the input side of the insulating unit 810, a transistor at the output side of the insulating unit 810 is turned on. The voltage output circuit 812 thereby outputs the voltage of the operation power source Vca. When the transistor is turned off, the capacitor is charged, and potential of the ground Ea is output from the voltage output circuit 812. The zero cross signal Xrs in accordance with the polarity (positive and negative) of the line voltage Vrs is thereby obtained. Specifically, the voltage of the operation power source Vca and the potential of the ground Ea is served as the zero cross signal Xrs in the operation of the active filter controller 27.

When the inverter controller 7 needs the zero cross signal Xrs, the zero cross signal generator 8A can be adopted not only in the second embodiment but also in the first embodiment.

As described above, the zero cross signal generator 8A can singly supply the zero cross signal Xrs to the inverter controller 7 as well as the active filter controller 27.

That is to say, the zero cross signal Xrs generated by the zero cross signal generator 8A, which is adopted as the voltage generator 8, is adopted to control both the inverter 4 and the active filter 200B. This is preferable in view of the reduction in a total number of components.

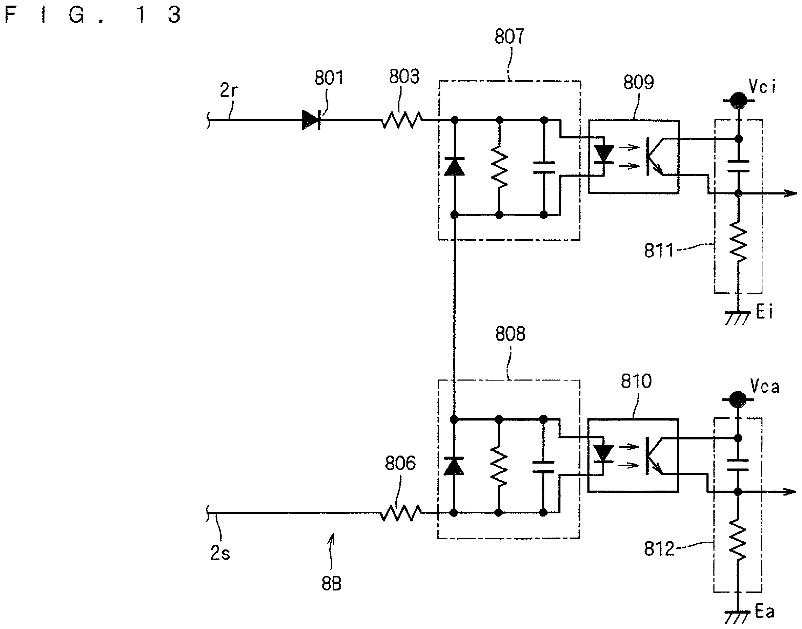

Fig. 13 is a circuit diagram illustrating a configuration of a zero cross signal generator 8B as an example. The zero cross signal generator 8B can also be adopted as the voltage detector 8.

The zero cross signal generator 8B has a configuration of removing the diode 802 and the resistors 804 and 805 from the zero cross signal generator 8A and series-connecting the voltage current conversion circuits 807 and 808 between the resistors 803 and 806.

Since the large voltage is applied to the diodes 801 and 802 and the resistors 803, 804, 805, and 806 in the zero cross signal generator 8A, so-called heavy electric components are necessary. These components for strong voltage is large in cost and shape.

On the other hand, in the zero cross signal generator 8B, the diode 801 and the resistors 803 and 806 double as the functions of the diode 802 and the resistors 804 and 805 in the zero cross signal generator 8A, respectively. Therefore, the zero cross signal generator 8B is preferable to the zero cross signal generator 8A in view of the reduction in the heavy electric components.

### Modification 2.

In the embodiment described above, the description of the case where the inverter controller 7 uses the information on the load currents Ir, Is, and It is omitted. When the inverter controller 7 uses the information on the load currents Ir, Is, and It, the load currents It and Ir detected by the current detector 3t and 3r are used, thus there is no need to provide a new current detector for the inverter controller 7.

That is to say, the load current It detected by the current detector 3t is adopted to control both the inverter 4 and the active filter 200B. This is also preferable in view of the reduction in the number of components.

Each configuration described in each embodiment and each modification example described above can be appropriately combined as long as they are not mutually inconsistent.

The present invention has been shown and described in detail, the foregoing description is in all aspects illustrative and not restrictive.

## Claims

1. An inverter substrate (100A, 100B), comprising:
first to third input terminals (5t, 5r, 5s) being connected to three-phase power source lines (1t, 1r, 1s) and to which three-phase AC voltages (Vt, Vr, Vs) are applied from the power source lines;
a first current detector (3t) configured to detect a current;
a voltage detector (8) configured to detect a line voltage (Vrs) between a pair (5r, 5s) among the first to third input terminals (5t, 5r, 5s) or a phase voltage (Vrn) of one of the AC voltages that is applied to the second input terminal (5r); and
an inverter (4);
**characterized by**
a pair of DC buses (LH, LL);
a rectifier circuit (2) having first to third input ends (2t, 2r, 2s) corresponding to the first to third input terminals (5t, 5r, 5s), respectively, and configured to rectify the AC voltages to apply DC voltage to the pair of DC buses; wherein
the first current detector (3t) is configured to detect a first current (It) flowing into the first input input end (2t)
the inverter (4) is configured to convert the DC voltage into different AC voltages (Vu, Vv, Vw) and to output the different AC voltages; and
a zero cross signal (Xrs) of the line voltage (Vrs) or the phase voltage (Vrn) is applied to control both the inverter (4) and a parallel active filter (200B), the line voltage (Vrs) or the phase voltage (Vrn) being detected by the voltage detector (8).

2. The inverter substrate (100B) according to claim 1, wherein
the parallel active filter (200B) is configured to provide the first to third input terminals (5t, 5r, 5s) with three-phase compensating currents (Iu, Iv, Iw) based on the line voltage (Vrs) or the phase voltage (Vrn), and the first current (It) by a predetermined correspondence relationship.

3. The inverter substrate (100B) according to claim 2, wherein
the first current (It) is applied to control both the inverter (4) and the parallel active filter (200B).

4. The inverter substrate (100A, 100B) according to any one of claims 1 to 3, wherein
the rectifier circuit (2) is configured to perform a six-pulse rectification.

5. A method of determining an order of connection between
an inverter substrate (100A, 100B) comprising
first to third input terminals (5t, 5r, 5s) being connected to three-phase power source lines (1t, 1r, 1s) and to which three-phase AC voltages (Vt, Vr, Vs) are applied from the three-phase power source lines (1t, 1r, 1s);
a pair of DC buses (LH, LL);
a rectifier circuit (2) having first to third input ends (2t, 2r, 2s) corresponding to the first to third input terminals (5t, 5r, 5s), respectively, rectifying the AC voltages to apply DC voltage to the pair of DC buses;
a first current detector (3t) detecting a first current (It) flowing in the first input end (2t);
a voltage detector (8) detecting a line voltage (Vrs) between a pair (5r, 5s) among the first to third input terminals (5t, 5r, 5s) or a phase voltage (Vrn) of one of the AC voltages that is applied to the second input terminal (5r); and
an inverter (4) converting the DC voltage into different AC voltages (Vu, Vv, Vw) and to output the different AC voltages;
and the three-phase power source lines (1t, 1r, 1s), wherein
a connection order describes an order in which the first to third input terminals (5t, 5r, 5s) are connected to the three-phase power source lines (1t, 1r, 1s) and is determined on the basis of the line voltage (Vrs) or the phase voltage (Vrn), and at least the first current (It).

6. The method of determining the connection order according to claim 5, wherein
the connection order between the first to third input terminals (5t, 5r, 5s) and the three-phase power source lines (1t, 1r, 1s) is determined by comparing the first current (It) at a specific point of time with at least one threshold value, and
the specific point of time is
a point of time after a lapse of time (td) of N/12 times a cycle of the line voltage, N = 1, 5, 7, or 11, from a point of time when the line voltage (Vrs) takes a value zero or
a point of time when the phase voltage (Vrn) takes a value zero or a point of time after a lapse of time (td) of M/12 times a cycle of the phase voltage, M = 2, 4, 6, 8, or 10, from the point of time.

7. The method of determining the connection order according to claim 5, wherein
the connection order between the first to third input terminals (5t, 5r, 5s) and the three-phase power source lines (1t, 1r, 1s) is determined by comparing an average value of the first current (It) in a specific period of time with at least one threshold value, and
the specific period of time is
a period of a length of time (d) of 1/12 times a cycle of the line voltage (Vrs) immediately after a lapse of time (td) of N/12 times the cycle, N = 1, 5, 7, or 11, from a point of time when the line voltage (Vrs) takes a value zero or
a period of a length of time (d) of 1/12 times a cycle of the phase voltage immediately after a point of time when the phase voltage (Vrn) takes a value zero or when time (td) of M/12 times the cycle, M = 2, 4, 6, 8, or 10, has elapsed from the point of time.

8. The method of determining the connection order according to claim 5, wherein
the connection order between the first to third input terminals (5t, 5r, 5s) and the three-phase power source lines (1t, 1r, 1s) is determined in accordance with increase and decrease in the first current (It) in a specific period of time, and
the specific period of time is
a period of a length of time (d) of 1/12 times a cycle of the line voltage (Vrs) immediately after a point of time when the line voltage (Vrs) takes a value zero or when time (td) of N/12 times the cycle, N = 2, 4, 6, or 10, has elapsed from the point of time or
a period of a length of time (d) of 1/12 times a cycle of the phase voltage immediately after a lapse of time (td) of M/12 times the cycle, M = 1, 3, 5, 7, 9, or 11, from a point of time when the phase voltage (Vrn) takes a value zero.

9. The method of determining the connection order according to claim 5, wherein
the connection order between the first to third input terminals (5t, 5r, 5s) and the three-phase power source lines (1t, 1r, 1s) is determined in accordance with a magnitude relationship at a specific point of time between the first current (It) and a second current (Ir) flowing in the second input end (2r), and
the specific point of time is
a point of time after a lapse of time (td) of N/12 times a cycle of the line voltage, N = 1, 5, 7, or 11, from a point of time when the line voltage (Vrs) takes a value zero or
a point of time when the phase voltage (Vrn) takes a value zero.

10. The method of determining the connection order according to claim 5, wherein
the connection order between the first to third input terminals (5t, 5r, 5s) and the three-phase power source lines (1t, 1r, 1s) is determined in accordance with a magnitude relationship at a specific point of time between the first current (It) and a second current (Is) flowing in the third input end (2s), and
the specific point of time is
a point of time after a lapse of time (td) of N/12 times a cycle of the line voltage, N = 1, 5, 7, or 11, from a point of time when the line voltage (Vrs) takes a value zero or
a point of time when the phase voltage (Vrn) takes a value zero or a point of time after a lapse of time (td) of M/12 times a cycle of the phase voltage, M = 2, 4, 6, 8, or 10, from the point of time.

11. The method of determining the connection order according to claim 9 or claim 10, wherein
the inverter substrate (100A, 100B) further includes a second current detector detecting the second current (Ir; Is).

12. The method of determining the connection order according to claim 9 or claim 10, wherein
the second current (Ir; Is) is estimated by shifting a phase of the first current (It).

13. The method of determining the connection order according to claim 5, wherein the inverter substrate further includes a second current detector detecting a second current (Ir; Is) flowing in one of the second input end (2r) and the third input end (2s),
the rectifier circuit (2) is a diode bridge,
a third current (Is; Ir) flowing in another one of the second input end and the third input end is obtained from the first current and the second current,
an estimated value (Φ^) of a phase (Φ) of one of the AC voltages (Vt, Vr, Vs) is obtained from the phase voltage (Vrn) or the line voltage (Vrs),
a current component (Id) having the same phase as a phase of the estimated value is obtained by performing a three phase/two phase conversion of the first current, the second current, and the third current on the basis of the estimated value, and
the connection order between the first to third input terminals (5t, 5r, and 5s) and the three-phase power source lines (1t, 1r, 1s) is determined in accordance with presence or absence of a variation of a polarity of the current component in a half cycle of the line voltage.

14. The method of determining the connection order according to claim 5, wherein the inverter substrate further includes a second current detector detecting a second current (Ir; Is) flowing in one of the second input end (2r) and the third input end (2s),
the rectifier circuit (2) is a diode bridge,
a third current (Is; It) flowing in another one of the second input end and the third input end is obtained from the first current and the second current,
an estimated value (Φ^) of a phase (Φ) of one of the AC voltages (Vt, Vr, Vs) is obtained from the phase voltage (Vrn) or the line voltage (Vrs),
a current component (Id; Iq), a phase of which is the same as or orthogonal to a phase of the estimated value, is obtained by performing a three phase/two phase conversion of the first current, the second current, and the third current on the basis of the estimated value, and
the connection order between the first to third input terminals (5t, 5r, 5s) and the three-phase power source lines (1t, 1r, 1s) is determined in accordance with a determination whether or not a DC component (Id0; Iq0) of the current component exceeds a predetermined value.

15. A method of determining an open phase in an inverter substrate (100A, 100B), said inverter substrate comprising
first to third input terminals (5t, 5r, 5s) being connected to three-phase power source lines (1t, 1r, 1s) and to which three-phase AC voltages (Vt, Vr, Vs) are applied from the power source lines;
a pair of DC buses (LH, LL);
a rectifier circuit (2) having first to third input ends (2t, 2r, 2s) corresponding to the first to third input terminals (5t, 5r, 5s), respectively, and rectifying the AC voltages to apply DC voltage to the pair of DC buses;
a first current detector (3t) detecting a first current (It) flowing in the first input end (2t);
a voltage detector (8) detecting a line voltage (Vrs) between a pair (5r, 5s) among the first to third input terminals (5t, 5r, 5s) or a phase voltage (Vrn) of one of the AC voltages that is applied to the second input terminal (5r); and
an inverter (4) converting the DC voltage into different AC voltages (Vu, Vv, Vw) and outputting the different AC voltages; wherein
it is determined that an open phase occurs in one of the first to third input terminals (5t, 5r, 5s) when a magnitude of the first current (It) at a specific point of time is smaller than a predetermined value, and
the specific point of time is
a point of time after a lapse of time (td) of N/12 times a cycle of the line voltage, N = 1, 5, 7, or 11, from a point of time when the line voltage (Vrs) takes a value zero, or
a point of time when the phase voltage (Vrn) takes a value zero.

## Patentansprüche

1. Invertersubstrat (100A, 100B), das Folgendes umfasst:
eine erste bis dritte Eingangsklemme (5t, 5r, 5s), die mit Dreiphasenstromquellenleitungen (1t, 1r, 1s) verbunden sind, und an die Dreiphasen-AC-Spannungen von den Stromquellenleitungen angelegt werden;
einen ersten Stromdetektor (3t), der dazu konfiguriert ist, einen Strom zu erfassen;
einen Spannungsdetektor (8), der dazu konfiguriert ist, eine Leitungsspannung (Vrs) zwischen einem Paar (5r, 5s) aus der ersten bis dritten Eingangsklemme (5t, 5r, 5s) oder eine Phasenspannung (Vrn) einer der AC-Spannungen, die an die zweite Eingangsklemme (5r) angelegt werden, zu erfassen; und
einen Inverter (4);
**gekennzeichnet durch**
ein Paar von DC-Bussen (LH, LL);
eine Gleichrichterschaltung (2), die ein erstes bis drittes Eingangsende (2t, 2r, 2s) aufweist, die jeweils der ersten bis dritten Eingangsklemme (5t, 5r, 5s) entsprechen, und die dazu konfiguriert ist, AC-Spannungen gleichzurichten, um DC-Spannung an das Paar von DC-Bussen anzulegen, wobei
der erste Stromdetektor (3t) dazu konfiguriert ist, einen ersten Strom (It), der in das erste Eingangsende (2t) fließt, zu erfassen,
der Inverter (4) dazu konfiguriert ist, die DC-Spannung in unterschiedliche AC-Spannungen (Vu, Vv, Vw) umzuwandeln und die unterschiedlichen AC-Spannungen auszugeben; und
wobei ein Nulldurchgangssignal (Xrs) der Leitungsspannung (Vrs) oder der Phasenspannung (Vrn) angelegt wird, um sowohl den Inverter (4) als auch ein paralleles Aktivfilter (200B) zu steuern, wobei die Leitungsspannung (Vrs) oder die Phasenspannung (Vrn) von dem Spannungsdetektor (8) erfasst wird.

2. Invertersubstrat (100B) nach Anspruch 1, wobei
das parallele Aktivfilter (200B) dazu konfiguriert ist, der ersten bis dritten Eingangsklemme (5t, 5r, 5s) Dreiphasen-Kompensationsströme (Iu, Iv, Iw) basierend auf der Leitungsspannung (Vrs) oder der Phasenspannung (Vrn) und dem ersten Strom (It) durch eine vorbestimmte Entsprechungsbeziehung bereitzustellen.

3. Invertersubstrat (100B) nach Anspruch 2, wobei
der erste Strom (It) sowohl an den Inverter (4) als auch an das parallele Aktivfilter (200B) angelegt wird.

4. Invertersubstrat (100A, 100B) nach einem der Ansprüche 1 bis 3, wobei
die Gleichrichterschaltung (2) dazu konfiguriert ist, eine Sechspulsgleichrichtung auszuführen.

5. Verfahren zum Bestimmen einer Verbindungsreihenfolge zwischen einem Invertersubstrat (100A, 100B), das Folgendes umfasst
eine erste bis dritte Eingangsklemme (5t, 5r, 5s), die mit Dreiphasenstromquellenleitungen (1t, 1r, 1s) verbunden sind, und an die Dreiphasen-AC-Spannungen (Vt, Vr, Vs) von den Stromquellenleitungen (1t, 1r, 1s) angelegt werden;
ein Paar von DC-Bussen (LH, LL);
eine Gleichrichterschaltung (2), die ein erstes bis drittes Eingangsende (2t, 2r, 2s) aufweist, die jeweils der ersten bis dritten Eingangsklemme (5t, 5r, 5s) entsprechen, die die AC-Spannungen gleichrichtet, um DC-Spannung an das Paar von DC-Bussen anzulegen;
einen ersten Stromdetektor (3t), der einen ersten Strom (It), der in das erste Eingangsende (2t) fließt, erfasst;
einen Spannungsdetektor (8), der eine Leitungsspannung (Vrs) zwischen einem Paar (5r, 5s) aus der ersten bis dritten Eingangsklemme (5t, 5r, 5s) oder eine Phasenspannung (Vrn) einer der AC-Spannungen, die an die zweite Eingangsklemme (5r) angelegt werden, erfasst; und
einen Inverter (4), der die DC-Spannung in unterschiedliche AC-Spannungen (Vu, Vv, Vw) umwandelt und die unterschiedlichen AC-Spannungen ausgibt;
und die Dreiphasenstromquellenleitungen (1t, 1r, 1s), wobei
eine Verbindungsreihenfolge eine Reihenfolge beschreibt, in der die erste bis dritte Eingangsklemme (5t, 5r, 5s) mit den Dreiphasenstromquellenleitungen (1t, 1r, 1s) verbunden werden und auf der Basis der Leitungsspannung (Vrs) oder der Phasenspannung (Vrn) und mindestens dem ersten Strom (It) bestimmt wird.

6. Verfahren zum Bestimmen der Verbindungsreihenfolge nach Anspruch 5, wobei
die Verbindungsreihenfolge zwischen der ersten bis dritten Eingangsklemme (5t, 5r, 5s) und den Dreiphasenstromquellenleitungen (1t, 1r, 1s) durch Vergleichen des ersten Stroms (It) an einem spezifischen Zeitpunkt mit mindestens einem Schwellenwert bestimmt wird, und
der spezifische Zeitpunkt
ein Zeitpunkt nach einer Zeitspanne (td) von N/12 Mal ein Zyklus der Leitungsspannung ist, N = 1, 5, 7 oder 11, seit einem Zeitpunkt, in dem die Leitungsspannung (Vrs) einen Wert null annimmt, ist, oder
ein Zeitpunkt, wenn die Phasenspannung (Vrn) einen Wert null annimmt, ein Zeitpunkt nach einer Zeitspanne (td) von M/12 Mal ein Zyklus der Phasenspannung, M = 2, 4, 6, 8 oder 10, seit dem Zeitpunkt ist.

7. Verfahren zum Bestimmen der Verbindungsreihenfolge nach Anspruch 5, wobei
die Verbindungsreihenfolge zwischen der ersten bis dritten Eingangsklemme (5t, 5r, 5s) und den Dreiphasenstromquellenleitungen (1t, 1r, 1s) durch Vergleichen eines Mittelwerts des ersten Stroms (It) in einer spezifischen Zeitperiode mit mindestens einem Schwellenwert bestimmt wird, und
der spezifische Zeitpunkt
eine Periode mit einer Zeitlänge (d) von 1/12 Mal ein Zyklus der Leitungsspannung (Vrs) unmittelbar nach einer Zeitspanne (td) von N/12 Mal der Zyklus, N = 1, 5, 7 oder 11, seit einem Zeitpunkt, in dem die Leitungsspannung (Vrs) einen Wert null annimmt, ist, oder
eine Periode mit einer Zeitlänge (d) von 1/12 Mal ein Zyklus der Phasenspannung unmittelbar nach einem Zeitpunkt, wenn die Phasenspannung (Vrn) einen Wert null annimmt, oder wenn die Zeit (td) von M/12 Mal der Zyklus, M = 2, 4, 6, 8 oder 10, seit dem Zeitpunkt verstrichen ist, ist.

8. Verfahren zum Bestimmen der Verbindungsreihenfolge nach Anspruch 5, wobei
die Verbindungsreihenfolge zwischen der ersten bis dritten Eingangsklemme (5t, 5r, 5s) und den Dreiphasenstromquellenleitungen (1t, 1r, 1s) gemäß Erhöhung und Verringerung des ersten Stroms (It) in einer spezifischen Zeitperiode bestimmt wird, und
der spezifische Zeitpunkt
eine Periode mit einer Zeitlänge (d) von 1/12 Mal ein Zyklus der Leitungsspannung (Vrs) unmittelbar nach einem Zeitpunkt, wenn die Leitungsspannung (Vrs) einen Wert null annimmt, oder wenn die Zeit (td) von N/12 Mal der Zyklus, N = 2, 4, 6 oder 10, seit dem Zeitpunkt verstrichen ist, ist, oder
eine Periode mit einer Zeitlänge (d) von 1/12 Mal ein Zyklus der Phasenspannung unmittelbar nach einer Zeitspanne (td) von M/12 Mal der Zyklus, M = 1, 3, 5, 7, 9 oder 11, seit einem Zeitpunkt, in dem die Phasenspannung (Vrs) einen Wert null annimmt, ist.

9. Verfahren zum Bestimmen der Verbindungsreihenfolge nach Anspruch 5, wobei
die Verbindungsreihenfolge zwischen der ersten bis dritten Eingangsklemme (5t, 5r, 5s) und den Dreiphasenstromquellenleitungen (1t, 1r, 1s) gemäß einer Größenbeziehung an einem spezifischen Zeitpunkt zwischen dem ersten Strom (It) und einem zweiten Strom (Ir), der in dem zweiten Eingangsende (2r) fließt, bestimmt wird, und
der spezifische Zeitpunkt
ein Zeitpunkt nach einer Zeitspanne (td) von N/12 Mal ein Zyklus der Leitungsspannung ist, N = 1, 5, 7 oder 11, seit einem Zeitpunkt, in dem die Leitungsspannung (Vrs) einen Wert null annimmt, ist, oder
ein Zeitpunkt, wenn die Phasenspannung (Vrn) einen Wert null annimmt, ist.

10. Verfahren zum Bestimmen der Verbindungsreihenfolge nach Anspruch 5, wobei
die Verbindungsreihenfolge zwischen der ersten bis dritten Eingangsklemme (5t, 5r, 5s) und den Dreiphasenstromquellenleitungen (1t, 1r, 1s) gemäß einer Größenbeziehung an einem spezifischen Zeitpunkt zwischen dem ersten Strom (It) und einem zweiten Strom (Is), der in dem dritten Eingangsende (2s) fließt, bestimmt wird, und
der spezifische Zeitpunkt
ein Zeitpunkt nach einer Zeitspanne (td) von N/12 Mal ein Zyklus der Leitungsspannung ist, N = 1, 5, 7 oder 11, seit einem Zeitpunkt, in dem die Leitungsspannung (Vrs) einen Wert null annimmt, ist, oder
ein Zeitpunkt, wenn die Phasenspannung (Vrn) einen Wert null annimmt, ein Zeitpunkt nach einer Zeitspanne (td) von M/12 Mal ein Zyklus der Phasenspannung, M = 2, 4, 6, 8 oder 10, seit dem Zeitpunkt ist.

11. Verfahren zum Bestimmen der Verbindungsreihenfolge nach Anspruch 9 oder Anspruch 10, wobei
das Invertersubstrat (100A, 100B) weiter einen zweiten Stromdetektor, der den zweiten Strom (Ir; Is) erfasst, beinhaltet.

12. Verfahren zum Bestimmen der Verbindungsreihenfolge nach Anspruch 9 oder Anspruch 10, wobei
der zweite Strom (Ir; Is) durch Verschieben einer Phase des ersten Stroms (It) geschätzt wird.

13. Verfahren zum Bestimmen der Verbindungsreihenfolge nach Anspruch 5, wobei
das Invertersubstrat weiter einen zweiten Stromdetektor beinhaltet, der einen zweiten Strom (Ir; Is), der in einem des zweiten Eingangsendes (2r) und des dritten Eingangsendes (2s) fließt, erfasst,
die Gleichrichterschaltung (2) eine Diodenbrücke ist,
ein dritter Strom (Is, Ir), der in einem anderen des zweiten Eingangsendes und des dritten Eingangsendes fließt, aus dem ersten Strom und dem zweiten Strom erhalten wird,
ein Schätzungswert (Φ^) einer Phase (Φ) einer der AC-Spannungen (Vt, Vr, Vs) aus der Phasenspannung (Vrn) oder der Leitungsspannung (Vrs) erhalten wird,
eine Stromkomponente (Id), die dieselbe Phase aufweist wie eine Phase des Schätzungswerts, durch Ausführen einer Dreiphasen-/Zweiphasenumwandlung des ersten Stroms, des zweiten Stroms und des drittens Stroms auf der Basis des Schätzungswerts erhalten wird, und
die Verbindungsreihenfolge zwischen der ersten bis dritten Eingangsklemme (5t, 5r und 5s) und den Dreiphasenstromquellenleitungen (1t, 1r, 1s) gemäß der Anwesenheit oder Abwesenheit einer Variation einer Polarität der Stromkomponente in einem Halbzyklus der Leitungsspannung bestimmt wird.

14. Verfahren zum Bestimmen der Verbindungsreihenfolge nach Anspruch 5, wobei
das Invertersubstrat weiter einen zweiten Stromdetektor beinhaltet, der einen zweiten Strom (Ir; Is), der in einem des zweiten Eingangsendes (2r) und des dritten Eingangsendes (2s) fließt, erfasst,
die Gleichrichterschaltung (2) eine Diodenbrücke ist,
ein dritter Strom (Is, It), der in einem anderen des zweiten Eingangsendes und des dritten Eingangsendes fließt, aus dem ersten Strom und dem zweiten Strom erhalten wird,
ein Schätzungswert (Φ^) einer Phase (Φ) einer der AC-Spannungen (Vt, Vr, Vs) aus der Phasenspannung (Vrn) oder der Leitungsspannung (Vrs) erhalten wird,
eine Stromkomponente (Id; Iq), von der eine Phase die gleiche ist wie eine Phase des Schätzungswert oder dazu orthogonal ist, durch Ausführen einer Dreiphasen-/Zweiphasenumwandlung des ersten Stroms, des zweiten Stroms und des drittens Stroms auf der Basis des Schätzungswerts erhalten wird, und
die Verbindungsreihenfolge zwischen der ersten bis dritten Eingangsklemme (5t, 5r 5s) und den Dreiphasenstromquellenleitungen (1t, 1r, 1s) gemäß einer Bestimmung, ob eine DC-Komponente (Id0; Iq0) der Stromkomponente einen vorbestimmten Wert überschreitet, bestimmt wird.

15. Verfahren zum Bestimmen einer offenen Phase in einem Invertersubstrat (100A, 100B), wobei das Invertersubstrat Folgendes umfasst
eine erste bis dritte Eingangsklemme (5t, 5r, 5s), die mit Dreiphasenstromquellenleitungen (1t, 1r, 1s) verbunden sind, und an die Dreiphasen-AC-Spannungen von den Stromquellenleitungen angelegt werden;
ein Paar von DC-Bussen (LH, LL);
eine Gleichrichterschaltung (2), die ein erstes bis drittes Eingangsende (2t, 2r, 2s) aufweist, die jeweils der ersten bis dritten Eingangsklemme (5t, 5r, 5s) entsprechen, und die die AC-Spannungen gleichrichtet, um DC-Spannung an das Paar von DC-Bussen anzulegen; einen ersten Stromdetektor (3t), der einen ersten Strom (It), der in dem ersten Eingangsende (2t) fließt, erfasst;
einen Spannungsdetektor (8), der eine Leitungsspannung (Vrs) zwischen einem Paar (5r, 5s) aus der ersten bis dritten Eingangsklemme (5t, 5r, 5s) oder eine Phasenspannung (Vrn) einer der AC-Spannungen, die an die zweite Eingangsklemme (5r) angelegt werden, erfasst; und
einen Inverter (4), der die DC-Spannung in unterschiedliche AC-Spannungen (Vu, Vv, Vw) umwandelt und die unterschiedlichen AC-Spannungen ausgibt; wobei,
falls bestimmt wird, dass eine offene Phase in einer der ersten bis dritten Eingangsklemmen (5t, 5r, 5s) auftritt, wenn eine Größe des ersten Stroms (It) in einem spezifischen Zeitpunkt kleiner ist als ein vorbestimmter Wert, und
der spezifische Zeitpunkt
ein Zeitpunkt nach einer Zeitspanne (td) von N/12 Mal ein Zyklus der Leitungsspannung, N = 1, 5, 7 oder 11, seit einem Zeitpunkt, in dem die Leitungsspannung (Vrs) einen Wert null annimmt, ist, oder
ein Zeitpunkt, wenn die Phasenspannung (Vrn) einen Wert null annimmt, ist.

## Revendications

1. Substrat d'onduleur (100A, 100B), comprenant :
des première à troisième bornes d'entrée (5t, 5r, 5s) étant connectées à des lignes de source d'alimentation électrique triphasée (1t, 1r, 1s) et auxquelles des tensions CA triphasées (Vt, Vr, Vs) sont appliquées à partir des lignes de source d'alimentation électrique ;
un premier détecteur de courant (3t) configuré pour détecter un courant ;
un détecteur de tension (8) configuré pour détecter une tension de ligne (Vrs) entre une paire (5r, 5s) parmi les première à troisième bornes d'entrée (5t, 5r, 5s) ou une tension de phase (Vrn) de l'une des tensions CA qui est appliquée à la troisième borne d'entrée (5r) ; et
un onduleur (4) ;
**caractérisé par**
une paire de bus CC (LH, LL) ;
un circuit redresseur (2) présentant des première à troisième extrémités d'entrée (2t, 2r, 2s) correspondant aux première à troisième bornes d'entrée (5t, 5r, 5s), respectivement, et configuré pour redresser les tensions CA afin d'appliquer une tension CC à la paire de bus CC ; dans lequel
le premier détecteur de courant (3t) est configuré pour détecter un premier courant (It) circulant dans la première extrémité d'entrée (2t)
l'onduleur (4) est configuré pour convertir la tension CC en une tension CA différente (Vu, Vv, Vw) et pour délivrer en sortie les tensions CA différentes ; et
un signal de passage par zéro (Xrs) de la tension de ligne (Vrs) ou de la tension de phase (Vrn) est appliqué pour commander à la fois l'onduleur (4) et un filtre actif parallèle (200B), la tension de ligne (Vrs) ou la tension de phase (Vrn) étant détectée par le détecteur de tension (8).

2. Substrat d'onduleur (100B) selon la revendication 1, dans lequel
le filtre actif parallèle (200B) est configuré pour fournir aux première à troisième bornes d'entrée (5t, 5r, 5s) des courants de compensation triphasés (Iu, Iv, Iw) basés sur la tension de ligne (Vrs) ou la tension de phase (Vrn), et le premier courant (It) par une relation de correspondance prédéterminée.

3. Substrat d'onduleur (100B) selon la revendication 2, dans lequel
le premier courant (It) est appliqué pour commander à la fois l'onduleur (4) et le filtre actif parallèle (200B).

4. Substrat d'onduleur (100A, 100B) selon l'une quelconque des revendications 1 à 3, dans lequel
le circuit redresseur (2) est configuré pour effectuer un redressement à six impulsions.

5. Procédé de détermination d'un ordre de connexion parmi un substrat d'onduleur (100A, 100B) comprenant
des première à troisième bornes d'entrée (5t, 5r, 5s) étant connectées à des lignes de source d'alimentation électrique triphasée (1t, 1r, 1s) et auxquelles des tensions CA triphasées (Vt, Vr, Vs) sont appliquées à partir des lignes de source d'alimentation électrique triphasée (1t, 1r, 1s) ;
une paire de bus CC (LH, LL) ;
un circuit redresseur (2) présentant des première à troisième extrémités d'entrée (2t, 2r, 2s) correspondant aux première à troisième bornes d'entrée (5t, 5r, 5s), respectivement, redressant les tensions CA pour appliquer une tension CC à la paire de bus CC ;
un premier détecteur de courant (3t) détectant un premier courant (It) circulant dans la première extrémité d'entrée (2t) ;
un détecteur de tension (8) détectant une tension de ligne (Vrs) entre une paire (5r, 5s) parmi les première à troisième bornes d'entrée (5t, 5r, 5s) ou une tension de phase (Vrn) de l'une des tensions CA qui est appliquée à la deuxième borne d'entrée (5r) ; et
un onduleur (4) convertissant la tension CC en des tensions CA différentes (Vu, Vv, Vw) et pour délivrer en sortie les tensions CA différentes ;
et les lignes de source d'alimentation électrique triphasée (1t, 1r, 1s), dans lequel
un ordre de connexion décrit un ordre dans lequel les première à troisième bornes d'entrée (5t, 5r, 5s) sont connectées aux lignes de source d'alimentation électrique triphasée (1t, 1r, 1s) et est déterminé sur la base de la tension de ligne (Vrs) ou de la tension de phase (Vrn), et d'au moins le premier courant (It).

6. Procédé de détermination de l'ordre de connexion selon la revendication 5, dans lequel
l'ordre de connexion entre les première à troisième bornes d'entrée (5t, 5r, 5s) et les lignes de source d'alimentation électrique triphasée (1t, 1r, 1s) est déterminé en comparant le premier courant (It) à un instant spécifique avec au moins une valeur de seuil, et
l'instant spécifique est
un instant après un laps de temps (td) de N/12 fois un cycle de la tension de ligne, N = 1, 5, 7 ou 11, à partir d'un instant où la tension de ligne (Vrs) prend une valeur nulle ou
un instant où la tension de phase (Vrn) prend une valeur nulle ou un instant après un laps de temps (td) de M/12 fois un cycle de la tension de phase, M = 2, 4, 6, 8, ou 10, à partir de l'instant.

7. Procédé de détermination de l'ordre de connexion selon la revendication 5, dans lequel
l'ordre de connexion entre les première à troisième bornes d'entrée (5t, 5r, 5s) et les lignes de source d'alimentation électrique triphasée (1t, 1r, 1s) est déterminé en comparant une valeur moyenne du premier courant (It) dans une période de temps spécifique avec au moins une valeur de seuil, et
la période de temps est
une période d'une durée (d) de 1/12 fois un cycle de la tension de ligne (Vrs) immédiatement après un laps de temps (td) de N/12 fois le cycle, N = 1, 5, 7, ou 11, à partir d'un instant où la tension de ligne (Vrs) prend une valeur nulle ou
une période d'une durée (d) de 1/12 fois un cycle de la tension de phase immédiatement après un instant où la tension de phase (Vrn) prend une valeur nulle ou lorsque le temps (td) de M/12 fois la cycle, M = 2, 4, 6, 8 ou 10, s'est écoulé depuis l'instant.

8. Procédé de détermination de l'ordre de connexion selon la revendication 5, dans lequel
l'ordre de connexion entre les première à troisième bornes d'entrée (5t, 5r, 5s) et les lignes de source d'alimentation électrique triphasée (1t, 1r, 1s) est déterminé en fonction de l'augmentation et de la diminution du premier courant (It) dans une période de temps spécifique, et
la période de temps est
une période d'une durée (d) de 1/12 fois un cycle de la tension de ligne (Vrs) immédiatement après un instant où la tension de ligne (Vrs) prend une valeur nulle ou lorsque le temps (td) de N/ 12 fois le cycle, N = 2, 4, 6 ou 10, s'est écoulé à partir de l'instant ou
une période d'une durée (d) de 1/12 fois un cycle de la tension de phase immédiatement après un laps de temps (td) de M/12 fois le cycle, M = 1, 3, 5, 7, 9, ou 11, à partir d'un instant où la tension de phase (Vrn) prend une valeur nulle.

9. Procédé de détermination de l'ordre de connexion selon la revendication 5, dans lequel
l'ordre de connexion entre les première à troisième bornes d'entrée (5t, 5r, 5s) et les lignes de source d'alimentation électrique triphasée (1t, 1r, 1s) est déterminé conformément à une relation d'amplitude à un instant spécifique entre le premier courant (It) et un deuxième courant (Ir) circulant dans la deuxième extrémité d'entrée (2r), et
l'instant spécifique est
un instant après un laps de temps (td) de N/12 fois un cycle de la tension de ligne, N = 1, 5, 7 ou 11, à partir d'un instant où la tension de ligne (Vrs) prend une valeur nulle ou
un instant où la tension de phase (Vrn) prend une valeur nulle.

10. Procédé de détermination de l'ordre de connexion selon la revendication 5, dans lequel
l'ordre de connexion entre les première à troisième bornes d'entrée (5t, 5r, 5s) et les lignes de source d'alimentation électrique triphasée (1t, 1r, 1s) est déterminé conformément à une relation d'amplitude à un instant spécifique entre le premier courant (It) et un deuxième courant (Is) circulant dans la troisième extrémité d'entrée (2s), et
l'instant spécifique est
un instant après un laps de temps (td) de N/12 fois un cycle de la tension de ligne, N = 1, 5, 7 ou 11, à partir d'un instant où la tension de ligne (Vrs) prend une valeur nulle ou
un instant où la tension de phase (Vrn) prend une valeur nulle ou un instant après un laps de temps (td) de M/12 fois un cycle de la tension de phase, M = 2, 4, 6, 8, ou 10, à partir de l'instant.

11. Procédé de détermination de l'ordre de connexion selon la revendication 9 ou la revendication 10, dans lequel
le substrat d'onduleur (100A, 100B) inclut en outre un second détecteur de courant détectant le deuxième courant (Ir ; Is).

12. Procédé de détermination de l'ordre de connexion selon la revendication 9 ou la revendication 10, dans lequel
le deuxième courant (Ir; Is) est estimé en décalant une phase du premier courant (It).

13. Procédé de détermination de l'ordre de connexion selon la revendication 5, dans lequel
le substrat inverseur inclut en outre un second détecteur de courant détectant un deuxième courant (Ir ; Is) circulant dans l'une de la deuxième extrémité d'entrée (2r) et de la troisième extrémité d'entrée (2s),
le circuit redresseur (2) est un pont de diodes,
un troisième courant (Is ; Ir) circulant dans une autre parmi la deuxième extrémité d'entrée et la troisième extrémité d'entrée est obtenu à partir du premier courant et du deuxième courant,
une valeur estimée (Φ^) d'une phase (Φ) de l'une des tensions CA (Vt, Vr, Vs) est obtenu à partir de la tension de phase (Vrn) ou de la tension de ligne (Vrs),
une composante de courant (Id) présentant la même phase qu'une phase de la valeur estimée est obtenue en effectuant une conversion triphasée/biphasée du premier courant, du deuxième courant et du troisième courant sur la base de la valeur estimée, et
l'ordre de connexion entre les première à troisième bornes d'entrée (5t, 5r et 5s) et les lignes de source d'alimentation électrique triphasée (1t, 1r, 1s) est déterminé en fonction de la présence ou de l'absence d'une variation d'une polarité de la composante de courant dans un demi-cycle de la tension de ligne.

14. Procédé de détermination de l'ordre de connexion selon la revendication 5, dans lequel
le substrat inverseur inclut en outre un second détecteur de courant détectant un deuxième courant (Ir ; Is) circulant dans l'une de la deuxième extrémité d'entrée (2r) et de la troisième extrémité d'entrée (2s),
le circuit redresseur (2) est un pont de diodes,
un troisième courant (Is ; It) circulant dans une autre parmi la deuxième extrémité d'entrée et la troisième extrémité d'entrée est obtenu à partir du premier courant et du deuxième courant,
une valeur estimée (Φ^) d'une phase (Φ) de l'une des tensions CA (Vt, Vr, Vs) est obtenu à partir de la tension de phase (Vrn) ou de la tension de ligne (Vrs),
une composante de courant (Id ; Iq), dont une phase est identique ou orthogonale à une phase de la valeur estimée, est obtenue en effectuant une conversion triphasée/biphasée du premier courant, du deuxième courant et du troisième courant sur la base de la valeur estimée, et
l'ordre de connexion entre les première à troisième bornes d'entrée (5t, 5r, 5s) et les lignes de source d'alimentation électrique triphasée (1t, 1r, 1s) est déterminé en fonction d'une détermination qu'une composante CC (Id0; Iq0) de la composante de courant dépasse ou non une valeur prédéterminée.

15. Procédé de détermination d'une phase ouverte dans un substrat d'onduleur (100A, 100B), ledit substrat d'onduleur comprenant
des première à troisième bornes d'entrée (5t, 5r, 5s) étant connectées à des lignes de source d'alimentation électrique triphasée (1t, 1r, 1s) et auxquelles des tensions CA triphasées (Vt, Vr, Vs) sont appliquées à partir des lignes de source d'alimentation électrique ;
une paire de bus CC (LH, LL) ;
un circuit redresseur (2) présentant des première à troisième extrémités d'entrée (2t, 2r, 2s) correspondant aux première à troisième bornes d'entrée (5t, 5r, 5s), respectivement, et redressant les tensions CA pour appliquer une tension CC à la paire de bus CC ; un premier détecteur de courant (3t) détectant un premier courant (It) circulant dans la première extrémité d'entrée (2t) ;
un détecteur de tension (8) détectant une tension de ligne (Vrs) entre une paire (5r, 5s) parmi les première à troisième bornes d'entrée (5t, 5r, 5s) ou une tension de phase (Vrn) de l'une des tensions CA qui est appliquée à la deuxième borne d'entrée (5r) ; et
un onduleur (4) convertissant la tension CC en des tensions CA différentes (Vu, Vv, Vw) et délivrant en sortie les tensions CA différentes ; dans lequel
il est déterminé qu'une phase ouverte survient dans une des première à troisième bornes d'entrée (5t, 5r, 5s) lorsqu'une amplitude du premier courant (It) à un instant spécifique est inférieure à une valeur prédéterminée, et
l'instant spécifique est
un instant après un laps de temps (td) de N/12 fois un cycle de la tension de ligne, N = 1, 5, 7 ou 11, à partir d'un instant où la tension de ligne (Vrs) prend une valeur nulle, ou
un instant où la tension de phase (Vrn) prend une valeur nulle.
